# EUROPEAN PATENT APPLICATION

(11) **EP 4 426 087 A1**
(43) Date of publication of application: **04.09.2024**
(21) Application number: 24156759.3
(22) Date of filing: 09.02.2024
(51) Int. Cl.: H10K 59/35, H10K 59/122, H10K 59/80

(54) **DISPLAY PANEL**

(30) Priority: 13.02.2023 KR 20230018859
(71) Applicant: Samsung Display Co., Ltd., Yongin-si, Gyeonggi-do 17113 (KR)
(72) Inventor: Lee, Sangshin, 17113 Giheung-gu, Yongin-si (KR); Park, Jongsung, 17113 Giheung-gu, Yongin-si (KR); Kang, Yeonju, 17113 Giheung-gu, Yongin-s (KR); Kim, Sanghoon, 17113 Giheung-gu, Yongin-si (KR)
(74) Representative: Dr. Weitzel & Partner

(57) **Abstract**

A display panel includes unit pixel areas defined in a first direction and a second direction, each of the unit pixel areas including: a first display element; a second display element; and a third display element. The first display element, the second display element, and the third display element are located along an oblique direction in each corresponding unit pixel area. A first emission area corresponding to the first display element includes a first emission portion and a second emission portion on a single first pixel electrode, and spaced from each other with respect to a virtual center line extending in a third direction, and a width of the first emission area in the third direction is less than a width of the first emission area in a fourth direction obliquely crossing the third direction.

## Description

### BACKGROUND

### 1. Field

The present invention relates to a display panel, and a display device including the display panel.

### 2. Description of the Related Art

Recently, uses of display devices have diversified. In addition, as display devices have become thinner and lightweight, the range of use thereof has widened.

As display devices have been used in various ways, there may be various methods for designing the shapes of display devices, and suitable functions that may be added or linked to display devices have increased.

The above information disclosed in this Background section is for enhancement of understanding of the background of the present invention, and therefore, it may contain information that does not constitute prior art.

### SUMMARY

One or more embodiments of the present invention are directed to a display device having improved display quality, while reducing an emission area loss. However, the aspect and features of the present invention are not limited thereto. The present invention is defined by the features of the independent claims. The dependent claims describe preferred embodiments.

Additional aspects and features of the present invention will be set forth, in part, in the description that follows, and in part, will be apparent from the description, or may be learned by practicing one or more of the presented embodiments of the present invention.

According to one or more embodiments of the present invention, a display panel includes unit pixel areas defined in a first direction and a second direction crossing the first direction, each of the unit pixel areas including: a first display element configured to emit light of a first color; a second display element configured to emit light of a second color; and a third display element configured to emit light of a third color. The first display element, the second display element, and the third display element are located along an oblique direction in each corresponding unit pixel area. A first emission area corresponding to the first display element is greater than each of a second emission area corresponding to the second display element and a third emission area corresponding to the third display element. The first emission area includes a first emission portion and a second emission portion on a single first pixel electrode and spaced from each other with respect to a virtual center line extending in a third direction. A width of the first emission area in the third direction is less than a width of the first emission area in a fourth direction obliquely crossing the third direction.

In an embodiment, the first pixel electrode may include: a first portion and a second portion spaced from each other with respect to the virtual center line extending in the third direction; and a third portion connecting between the first portion and the second portion.

In an embodiment, the first emission portion of the first emission area may be located on the first portion of the first pixel electrode, and the second emission portion of the first emission area may be located on the second portion of the first pixel electrode.

In an embodiment, the first emission area may further include a third emission portion connecting between the first emission portion and the second emission portion, and at least a portion of the third emission portion may be located on the third portion of the first pixel electrode.

In an embodiment, a pixel-defining layer may be located on at least a portion of the third portion of the first pixel electrode.

In an embodiment, a distance between the first emission portion and the second emission portion of the first emission area may be less than a distance between the second emission area and the third emission area.

In an embodiment, the first emission area may further include a third emission portion connecting between the first emission portion and the second emission portion.

In an embodiment, the unit pixel areas may include a first unit pixel area and a second unit pixel area alternately located with each other along the first direction. In the first unit pixel area, the first emission portion and the second emission portion of the first emission area may be spaced from each other in a first oblique direction. In the second unit pixel area, the first emission portion and the second emission portion of the first emission area may be spaced from each other in a second oblique direction perpendicular to the first oblique direction.

In an embodiment, the unit pixel areas may include a first unit pixel area and a second unit pixel area alternately located with each other along the first direction, and a direction in which the first emission portion and the second emission portion of the first emission area located within the first unit pixel area are spaced from each other may be the same as a direction in which the first emission portion and the second emission portion of the first emission area located within the second unit pixel area are spaced from each other.

In an embodiment, the third direction may be the oblique direction.

In an embodiment, the third direction may be parallel to the first direction.

In an embodiment, an angle between the third direction and the fourth direction may be about 45°.

In an embodiment, the unit pixel areas may include a first unit pixel area and a second unit pixel area. In the first unit pixel area, the second emission area and the third emission area may face each other in a third oblique direction, and the first emission area may be adjacent to the second emission area and the third emission area in a fourth oblique direction. In the second unit pixel area, the third emission area, the second emission area, and the first emission area may be sequentially located to be adjacent to each other in the fourth oblique direction.

According to one or more embodiments of the present invention, a display panel includes unit pixel areas defined in a first direction and a second direction crossing the first direction, each of the unit pixel areas including: a first display element configured to emit light of a first color, and having at least one surface along an oblique direction; a second display element configured to emit light of a second color; and a third display element configured to emit light of a third color. The first display element is adjacent to the second display element and the third display element in the first direction, and the second display element and the third display element are adjacent to each other in the second direction. A first emission area corresponding to the first display element includes a first emission portion and a second emission portion on a single first pixel electrode and spaced from each other with respect to a virtual center line extending in a third direction. A width of the first emission area in the third direction is less than a width of the first emission area in a fourth direction obliquely crossing the third direction.

In an embodiment, each of a second emission area corresponding to the second display element and a third emission area corresponding to the third display element may be less than the first emission area.

In an embodiment, at least one surface of each of the second emission area and the third emission area may be located in an oblique direction.

In an embodiment, each of the second emission area and the third emission area may have a triangular shape, a pentagonal shape, or a hexagonal shape.

In an embodiment, the first pixel electrode may include: a first portion and a second portion spaced from each other with respect to the virtual center line extending in the third direction; and a third portion connecting between the first portion and the second portion.

In an embodiment, the first emission portion of the first emission area may be located on the first portion of the first pixel electrode, and the second emission portion of the first emission area may be located on the second portion of the first pixel electrode.

In an embodiment, the first emission area may further include a third emission portion connecting between the first emission portion and the second emission portion, and at least a portion of the third emission portion may be located on the third portion of the first pixel electrode.

In an embodiment, a pixel-defining layer may be located on at least a portion of the third portion of the first pixel electrode.

According to one or more embodiments of the present invention, a display panel includes unit pixel areas defined in a first direction and a second direction crossing the first direction, each of the unit pixel areas including: a first display element configured to emit light of a first color, and having at least one surface in an oblique direction; a second display element configured to emit light of a second color; and a third display element configured to emit light of a third color. A first emission area corresponding to the first display element is greater than each of a second emission area corresponding to the second display element and a third emission area corresponding to the third display element. The first emission area is on a single first pixel electrode and includes a first emission portion and a second emission portion spaced from each other with respect to a virtual center line extending in a third direction. A width of the first emission area in the third direction is less than a width of the first emission area in a fourth direction obliquely crossing the third direction.

In an embodiment, at least one surface of each of the second emission area and the third emission area may be located in an oblique direction.

In an embodiment, the unit pixel areas may include a first unit pixel area and a second unit pixel area alternately located with each other in the first direction. In the first unit pixel area, the second emission area and the third emission area may face each other in a first oblique direction, and the first emission area may be adjacent to the second emission area and the third emission area in a second oblique direction. In the second unit pixel area, the third emission area, the second emission area, and the first emission area may be sequentially located to be adjacent to each other in the second oblique direction.

In an embodiment, the unit pixel areas may include a first unit pixel area and a second unit pixel area alternately located with each other in the first direction. The first emission area may be adjacent to the second emission area and the third emission area in the first direction, and the second emission area and the third emission area may be adjacent to each other in the second direction.

### BRIEF DESCRIPTION OF THE DRAWINGS

The above and other aspects and features of the present invention will be more clearly understood from the following detailed description of the illustrative, nonlimiting embodiments with reference to the accompanying drawings, in which:
FIG. 1 is a plan view schematically illustrating a display device according to an embodiment;
FIGS. 2-4 are cross-sectional views schematically illustrating a cross-section of a portion of a display device according to one or more embodiments;
FIGS. 5-10 are diagrams illustrating various arrangements of pixels according to one or more embodiments;
FIGS. 11-15 are diagrams illustrating various arrangements of pixels according to one or more embodiments; and
FIG. 16 is a table showing aperture ratios and life according to division directions of emission areas of display elements.

### DETAILED DESCRIPTION

Hereinafter, embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that when a wire is referred to as "extending in a first direction or a second direction," it may not only extend in a linear shape, but may also extend in the first direction or the second direction in a zigzag or curved line shape.

As used herein, the expression "in a plan view" refers to a view of an object from above, and the expression "in a cross-sectional view" refers to a view of a cross-section of an object formed by vertically cutting the object and viewing from the side. As used herein, when a first element is described as "overlapping," "overlapping with" "overlaps" or "overlaps with" a second element, the first element may be located above or below the second element.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present invention. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present invention refers to "one or more embodiments of the present invention." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

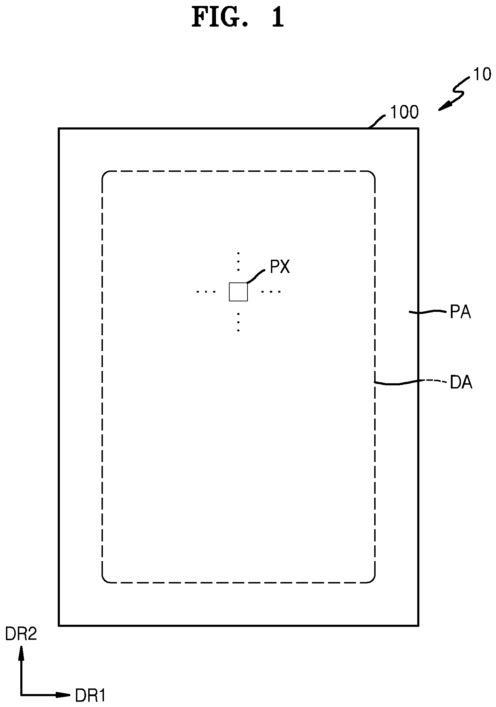

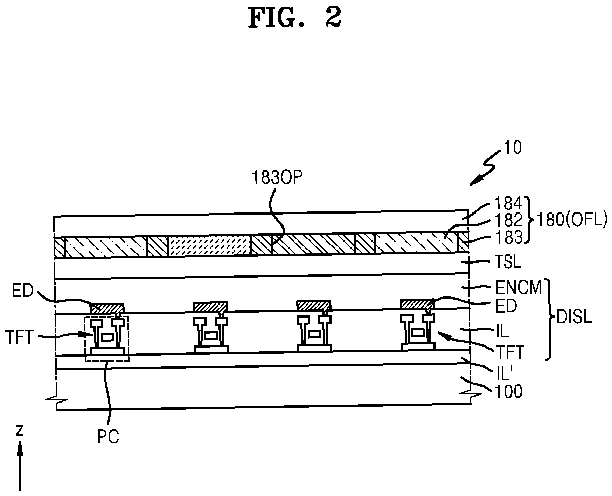

FIG. 1 is a plan view schematically illustrating a display device according to an embodiment. FIGS. 2 through 4 are cross-sectional views schematically illustrating a cross-section of a portion of a display device according to one or more embodiments.

Referring to FIG. 1, the display device includes a display panel 10. A cover window for protecting the display panel 10 may be further disposed above the display panel 10.

The display panel 10 may include a display area DA on which an image is implemented, and a peripheral area PA outside the display area DA. The peripheral area PA may be a kind of non-display area on which pixels PX are not arranged. The display area DA may be entirely surrounded (e.g., around a periphery thereof) by the peripheral area PA. Various elements included in the display panel 10 may be disposed on a substrate 100. Accordingly, the substrate 100 may be regarded as including the display area DA and the peripheral area PA.

A plurality of pixels PX may be arranged in the display area DA. The pixel PX may include a display element. The display element may be connected to a pixel circuit for driving the pixel PX. In an embodiment, the display element may be an organic light-emitting diode OLED. Each of the pixels PX may emit, for example, red, green, blue, or white light through a corresponding organic light-emitting diode OLED.

In a plan view, the display area DA may have a rectangular shape, as shown in FIG. 1. In another embodiment, the display area DA may have another suitable polygonal shape, such as a triangle, a pentagon, or a hexagon, or a circular shape, an elliptical shape, or an atypical shape.

The peripheral area PA is an area arranged around (e.g., adjacent to) the display area DA, and may be an area on which an image is not displayed. Various lines for transmitting electrical signals to be applied to the display area DA, external circuits electrically connected to the pixel circuits, and pads to which a printed circuit board or a driver integrated circuit (IC) chip are attached may be located in the peripheral area PA.

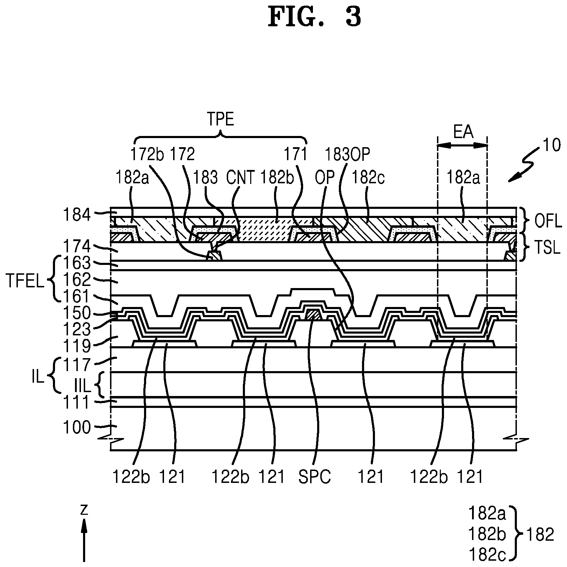

Referring to FIGS. 2 and 3, the display panel 10 may include a display layer DISL, a touch screen layer TSL, and an optical functional layer OFL on the substrate 100.

The display layer DISL may include a pixel circuit PC including a thin-film transistor TFT, an emission element ED, which is a display element, and an encapsulation member ENCM, such as a thin-film encapsulation layer TFEL or an encapsulation substrate. Insulating layers IL and IL' may be arranged between the substrate 100 and the display layer DISL and within the display layer DISL. In FIG. 3, the pixel circuit PC is not shown for convenience of illustration.

The substrate 100 may be a single layer of a glass material. As another example, the substrate 100 may include a polymer resin. The substrate 100 including the polymer resin may have a multi-layered structure in which an organic layer including the polymer resin and an inorganic layer are stacked. The substrate 100 may be a rigid substrate, or a flexible substrate capable of being bent, folded, or rolled.

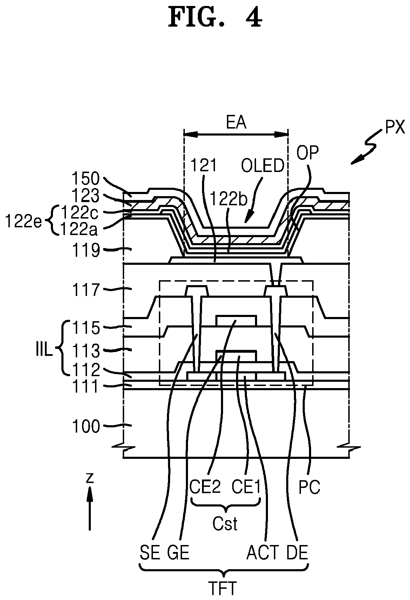

A buffer layer 111, an inorganic insulating layer IIL, and a planarization layer 117 may be sequentially stacked on the substrate 100. The planarization layer 117 may include an organic material or an inorganic material, and may have a single-layer structure or a multi-layered structure. The pixel circuit PC may be arranged between the buffer layer 111 and the planarization layer 117. As shown in FIG. 4, the pixel circuit PC may include a thin-film transistor TFT and a capacitor Cst.

The thin-film transistor TFT may include a semiconductor layer ACT, a gate electrode GE, a source electrode SE, and a drain electrode DE. The semiconductor layer ACT may include an semiconductor material, such as amorphous silicon or polycrystalline silicon, or an oxide semiconductor. The capacitor Cst may include a lower electrode CE1 and an upper electrode CE2.

The semiconductor layer ACT may be disposed on the buffer layer 111. A first insulating layer 112 may be located between the semiconductor layer ACT and the gate electrode GE. A second insulating layer 113 may be disposed on the gate electrode GE, and the upper electrode CE2 of the capacitor Cst may be disposed on the second insulating layer 113. The upper electrode CE2 may overlap with the gate electrode GE thereunder. The gate electrode GE and the upper electrode CE2 overlapping with each other with the second insulating layer 113 therebetween may form the capacitor Cst. The gate electrode GE may be the lower electrode CE1 of the capacitor Cst. A third insulating layer 115 may be disposed on the capacitor Cst, and the source electrode SE and the drain electrode DE may be disposed on the third insulating layer 115.

Each of the first insulating layer 112, the second insulating layer 113, and the third insulating layer 115 may include silicon oxide, silicon nitride, and/or silicon oxynitride. The first insulating layer 112, the second insulating layer 113, and the third insulating layer 115 may be collectively referred to as an inorganic insulating layer IIL.

The buffer layer 111 including an inorganic material, such as silicon oxide, silicon nitride, and/or silicon oxynitride, may be arranged between the thin-film transistor TFT and the substrate 100.

The planarization layer 117 may be disposed on the thin-film transistor TFT. The planarization layer 117 may include an organic insulating material, such as acrylic resin, benzocyclobutene (BCB), or hexamethyldisiloxane (HMDSO). The planarization layer 117 may include an inorganic insulating material, such as silicon oxide (SiOₓ), silicon nitride (SiNₓ), silicon oxynitride (SiON), aluminum oxide (Al₂O₅), titanium oxide (TiO₂), tantalum oxide (Ta₂O₅), hafnium oxide (HfO₂), or zinc oxide (ZnO₂). When forming the planarization layer 117, after forming a corresponding layer thereof, chemical mechanical polishing may be performed on the upper surface of the corresponding layer to provide a flat or substantially flat upper surface. The planarization layer 117 may be a single layer or multi-layers.

An organic light-emitting diode OLED, which is a display element, may be disposed on the planarization layer 117 as an emission element ED. The organic light-emitting diode OLED may include a pixel electrode 121, an opposite electrode 123, and an intermediate layer between the pixel electrode 121 and the opposite electrode 123.

The pixel electrode 121 may be disposed on the planarization layer 117, and the pixel electrode 121 may be electrically connected to the thin-film transistor TFT to be in contact with the source electrode SE or the drain electrode DE through a via hole of (e.g., penetrating) the planarization layer 117.

A pixel-defining layer 119 may be disposed on the planarization layer 117. The pixel-defining layer 119 may cover an edge of the pixel electrode 121, and may have an opening OP exposing a portion of the pixel electrode 121. A size and shape of an emission area EA of the organic light-emitting diode OLED may be defined by the opening OP.

The pixel-defining layer 119 may include a transparent insulating material or an opaque insulating material. In an embodiment, the pixel-defining layer 119 may include an organic insulating material, such as polyimide, polyamide, acrylic resin, BCB, HMDSO, and/or phenolic resin. In another embodiment, the pixel-defining layer 119 may include an inorganic insulating material, such as silicon nitride or silicon oxide, or may include an organic insulating material and an inorganic insulating material.

In some embodiments, the pixel-defining layer 119 may include a light-blocking material, and may be provided to have a black color. The light-blocking material may include a resin or a paste including carbon black, carbon nanotube, and/or a black dye, metal particles, such as nickel, aluminum, molybdenum, and/or any suitable alloys thereof, metal oxide particles (e.g., chromium oxide), or metal nitride particles (e.g., chromium nitride). When the pixel-defining layer 119 includes a light-blocking material, reflection of external light by metal structures disposed under the pixel-defining layer 119 may be reduced.

As shown in FIG. 3, a spacer SPC may be further provided on the pixel-defining layer 119. In an embodiment, the spacer SPC may include the same material as that of the pixel-defining layer 119. In this case, the pixel-defining layer 119 and the spacer SPC may be formed together in a mask process using a halftone mask and/or the like, so that the spacer SPC may have an island shape protruding from the pixel-defining layer 119 at a suitable interval (e.g., a certain or predetermined interval) in the z direction. The z direction may be perpendicular to or substantially perpendicular to each of a first direction DR1 and a second direction DR2 (e.g., see FIG. 1). In another embodiment, the spacer SPC may include a material different from a material of the pixel-defining layer 119. In this case, the spacer SPC may include (e.g., may be) island-shaped insulating patterns arranged at suitable intervals (e.g., certain or predetermined intervals) on the pixel-defining layer 119.

As shown in FIG. 4, the intermediate layer may include an emission layer 122b, and an organic functional layer 122e above and/or below the emission layer 122b.

The emission layer 122b may be arranged in the opening OP of the pixel-defining layer 119 to correspond to the pixel electrode 121. The emission layer 122b may include a polymer material or a low-molecular material, and may emit red, green, blue, or white light.

The organic functional layer 122e may include a first functional layer 122a and/or a second functional layer 122c. The first functional layer 122a or the second functional layer 122c may be omitted as needed or desired.

The first functional layer 122a may be disposed below (e.g., underneath) the emission layer 122b. The first functional layer 122a may be a single layer or multi-layers including (e.g., made of) an organic material. The first functional layer 122a may be a hole transport layer (HTL) having a single-layer structure. As another example, the first functional layer 122a may include a hole injection layer (HIL) and an HTL. The first functional layer 122a may be integrally formed (e.g., commonly formed) as a single body to correspond to the organic light-emitting diodes OLED included in the display area DA.

The second functional layer 122c may be disposed on the emission layer 122b. The second functional layer 122c may be a single layer or multi-layers including (e.g., made of) an organic material. The second functional layer 122c may include an electron transport layer (ETL) and/or an electron injection layer (EIL). The second functional layer 122c may be integrally formed (e.g., commonly formed) as a single body to correspond to the organic light-emitting diodes OLED included in the display area DA.

The opposite electrode 123 may be disposed on the emission layer 122b. An upper layer 150 including an organic material may be disposed on the opposite electrode 123.

In some embodiments, the intermediate layer may include two or more emitting units (e.g., emitters), which are sequentially stacked between the pixel electrode 121 and the opposite electrode 123, and a charge generation layer (CGL) arranged between the two emitting units. When the intermediate layer includes the emitting units and the CGL, the organic light-emitting diode OLED may be a tandem emission element. Due to a stacked structure of a plurality of emitting units (e.g., a plurality of emitters), color purity and luminous efficiency of the organic light-emitting diode OLED may be improved.

One emitting unit (e.g., one emitter) may include an emission layer, and a first functional layer and a second functional layer below and above the emission layer, respectively. The CGL may include a negative charge generation layer and a positive charge generation layer. The luminance efficiency of the organic light-emitting diode OLED, which is a tandem emission element having a plurality of emission layers, may be further increased by the negative charge generation layer and the positive charge generation layer. The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material.

The upper layer 150 may be a layer provided to protect the opposite electrode 123, and may increase light extraction efficiency. The upper layer 150 may include lithium fluoride (LiF). As another example, the upper layer 150 may additionally include an inorganic insulating material, such as silicon oxide (SiOₓ) and/or silicon nitride (SiNₓ).

The display elements may be covered by the thin-film encapsulation layer TFEL. In an embodiment, the thin-film encapsulation layer TFEL may include at least one inorganic encapsulation layer and at least one organic encapsulation layer. For example, the thin-film encapsulation layer TFEL may include first and second inorganic encapsulation layers 161 and 163, and an organic encapsulation layer 162 therebetween. In another embodiment, an encapsulation substrate may be disposed on the organic light-emitting diode OLED instead of the thin-film encapsulation layer TFEL, as described above.

The touch screen layer TSL may be disposed on the second inorganic encapsulation layer 163. The touch screen layer TSL may obtain coordinate information according to an external input, for example, such as a touch event. The touch screen layer TSL may detect an external input by using a self-capacitance method or a mutual capacitance method. The touch screen layer TSL may include touch electrodes TPE, and lines connected to the touch electrodes TPE. The touch electrodes TPE may include first touch electrodes 171 and second touch electrodes 172. The first touch electrodes 171 may be connected by connection electrodes arranged at (e.g., in or on) the same layer. The second touch electrodes 172 may be connected to the connection electrodes disposed at (e.g., in or on) another layer through a contact hole CNT of (e.g., penetrating) an insulating layer 174. The touch electrodes TPE may be located to correspond to (e.g., overlap with) the pixel-defining layer 119.

The optical functional layer OFL may include a filter layer 180 including a color filter 182, a black matrix 183, and an overcoat layer 184. The black matrix 183 may cover the first touch electrodes 171 and the second touch electrodes 172. The black matrix 183 may be located to correspond to (e.g., overlap with) the pixel-defining layer 119. The overcoat layer 184 may include an organic material, such as a resin, and the organic material may be transparent.

In the display panel 10 including the color filter 182 and the black matrix 183 as the optical functional layer OFL instead of a polarizing plate or a polarizing film, the luminance efficiency of the display element may be improved, thereby decreasing power consumption and increasing luminance. Accordingly, the lifetime of the display panel 10 may increase. In addition, the same or higher luminance/lifetime may be ensured, even if an an area of the emission area is smaller than that of a comparative emission area. In addition, because a polarizing plate or a polarizing film itself is not used, a thickness of the display panel 10 may be reduced.

The color filter 182 may include a first color filter 182a for selectively transmitting only light of a first color, a second color filter 182b for selectively transmitting only light of a second color, and a third color filter 182c for selectively transmitting only light of a third color. The first color filter 182a, the second color filter 182b, and the third color filter 182c may be arranged to correspond to (e.g., overlap with) the emission areas EA of the pixels PX. The first color filter 182a, the second color filter 182b, and the third color filter 182c may be arranged to be adjacent to each other. Each of the first color filter 182a, the second color filter 182b, and the third color filter 182c may have an independent pattern structure. Each of the first color filter 182a, the second color filter 182b, and the third color filter 182c may be arranged in a corresponding opening 183OP of the black matrix 183. Each of the first color filter 182a, the second color filter 182b, and the third color filter 182c may partially overlap with the pixel-defining layer 119.

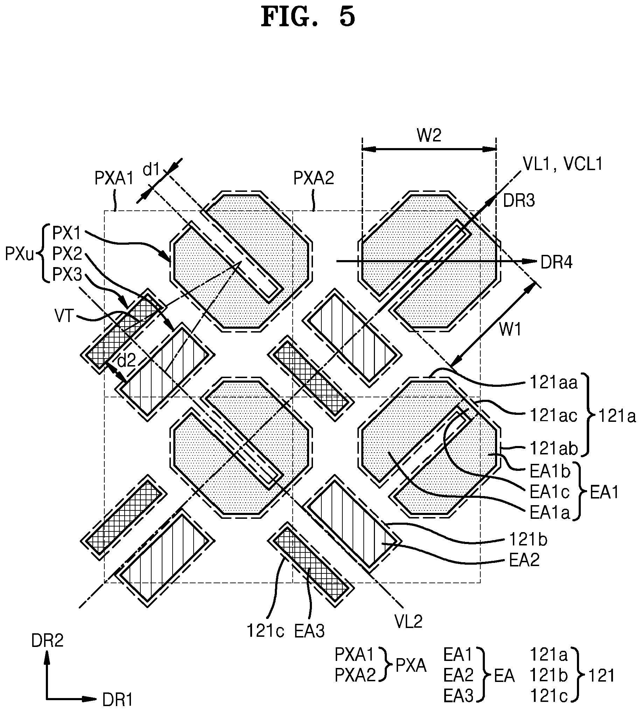

FIGS. 5 through 10 are diagrams illustrating various arrangements of pixels according to one or more embodiments. FIGS. 5 through 10 are plan views showing a first unit pixel area PXA1 and a second unit pixel area PXA2, each including a first pixel PX1, a second pixel PX2, and a third pixel PX3.

In the display area DA (e.g., see FIG. 1) of the display panel 10, unit pixel areas PXA are defined along a first direction DR1 and a second direction DR2 crossing (e.g., intersecting) the first direction DR1, and a unit pixel PXu may be arranged in each of the unit pixel areas PXA. The unit pixel PXu may include the first pixel PX1, the second pixel PX2, and the third pixel PX3. Display elements of the first pixel PX1, the second pixel PX2, and the third pixel PX3 may be arranged in the unit pixel area PXA in a suitable pattern (e.g., a certain or predetermined pattern) according to a suitable rule (e.g., a certain or predetermined rule). In an embodiment, the unit pixel area PXA may have a square shape. The unit pixel areas PXA may include the first unit pixel area PXA1 and the second unit pixel area PXA2, which are alternately located with each other along the first direction DR1.

Each of the first pixel PX1, the second pixel PX2, and the third pixel PX3 may be one of a blue pixel for emitting blue light, a red pixel for emitting red light, or a green pixel for emitting green light. For example, the first pixel PX1 may be a blue pixel for emitting blue light, the second pixel PX2 may be a green pixel for emitting green light, and the third pixel PX3 may be a red pixel for emitting red light. However, the present invention is not limited thereto, and various suitable modifications may be made in various suitable combinations, as would be understood by those having ordinary skill in the art. For example, the first pixel PX1 may be a green pixel for emitting green light, the second pixel PX2 may be a red pixel for emitting red light, and the third pixel PX3 may be a blue pixel for emitting blue light. Each of the first pixel PX1, the second pixel PX2, and the third pixel PX3 may include an organic light-emitting diode OLED, which is a display element, and a pixel circuit connected to the organic light-emitting diode OLED.

A size and shape of the emission area EA of the organic light-emitting diode OLED is defined by the opening OP of the pixel-defining layer 119 described above with reference to FIG. 4, and the emission area EA is an area in which an emission layer 122b of the organic light-emitting diode OLED is arranged. Accordingly, in as used in the present disclosure, an array (e.g., an arrangement) of pixels may refer to (e.g., may mean) an array (e.g., an arrangement) of the display elements, an array (e.g., an arrangement) of the pixel electrodes, or an array (e.g., an arrangement) of the emission areas.

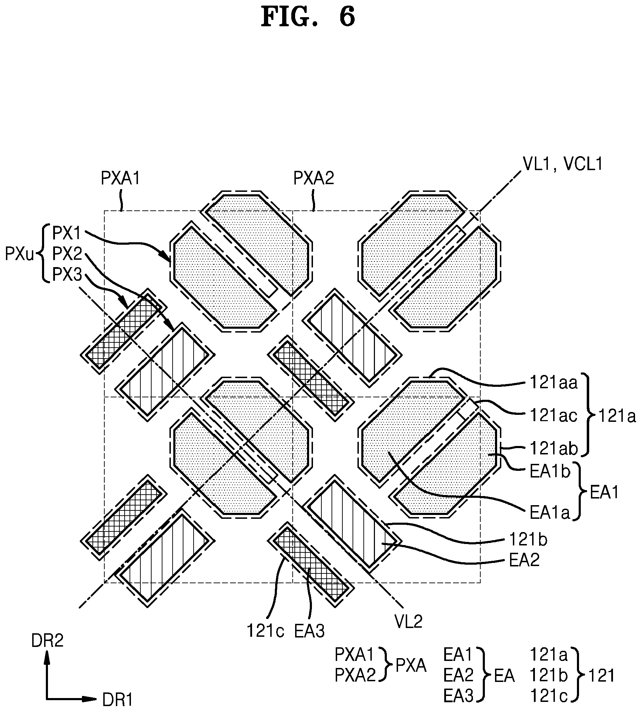

FIGS. 5 and 6 show pixel electrodes 121 and emission areas EA corresponding to a first display element of the first pixel PX1, a second display element of the second pixel PX2, and a third display element of the third pixel PX3, which are arranged in each of the first unit pixel area PXA1 and the second unit pixel area PXA2.

Referring to FIGS. 5 and 6, the first unit pixel area PXA1 and the second unit pixel area PXA2 may be alternately located with each other in the display area DA along the first direction DR1. The first display element of the first pixel PX1, the second display element of the second pixel PX2, and the third display element of the third pixel PX3 may be arranged along an oblique direction within the first unit pixel area PXA1 and the second unit pixel area PXA2. An area of the second display element and an area of the third display element may each be smaller than an area of the first display element.

The emission area EA may include a first emission area EA1 corresponding to the first display element of the first pixel PX1, a second emission area EA2 corresponding to the second display element of the second pixel PX2, and a third emission area EA3 corresponding to the third display element of the third pixel PX3.

In the first unit pixel area PXA1, the second emission area EA2 of the second pixel PX2 and the third emission area EA3 of the third pixel PX3 may be arranged to be adjacent to each other along a second virtual straight line VL2 in an oblique direction. In the first unit pixel area PXA1, the second emission area EA2 of the second pixel PX2 and the third emission area EA3 of the third pixel PX3 may be arranged to face each other with respect to the second virtual straight line VL2 in the oblique direction. In the first unit pixel area PXA1, the first emission area EA1 of the first pixel PX1 may be arranged adjacent to the second emission area EA2 of the second pixel PX2 and the third emission area EA3 of the third pixel PX3 along a first virtual straight line VL1 in an oblique direction. In the first unit pixel area PXA1, centers of the first emission area EA1 of the first pixel PX1, the second emission area EA2 of the second pixel PX2, and the third emission area EA3 of the third pixel PX3 may be located at vertices of a virtual triangle VT.

In the second unit pixel area PXA2, the third emission area EA3 of the third pixel PX3, the second emission area EA2 of the second pixel PX2, and the first emission area EA1 of the first pixel PX1 may be sequentially arranged to be adjacent to each other along the first virtual straight line VL1, which is an oblique direction. In the second unit pixel area PXA2, the second emission area EA2 of the second pixel PX2 may be arranged between the first emission area EA1 of the first pixel PX1 and the third emission area EA3 of the third pixel PX3.

The first emission area EA1 of the first pixel PX1, the second emission area EA2 of the second pixel PX2, and the third emission area EA3 of the third pixel PX3 may have different areas or sizes from each other. In an embodiment, the first emission area EA1 of the first pixel PX1 may have a larger area than the second emission area EA2 of the second pixel PX2. In addition, the first emission area EA1 of the first pixel PX1 may have a larger area than the third emission area EA3 of the third pixel PX3. In an embodiment, the second emission area EA2 of the second pixel PX2 may have a larger area than the third emission area EA3 of the third pixel PX3. In another embodiment, the second emission area EA2 of the second pixel PX2 may have the same or substantially the same size area as the third emission area EA3 of the third pixel PX3.

The first emission area EA1 may have at least one surface arranged in an oblique direction. The first emission area EA1 may include a first emission portion EA1a and a second emission portion EA1b spaced apart from each other. At least a portion of the first emission area EA1 may be separated based on a virtual center line VCL1 extending in a third direction DR3. The first emission portion EA1a and the second emission portion EA1b of the first emission area EA1 may be portions spaced apart (e.g., separated) from each other based on the virtual center line VCL1 extending in the third direction DR3.

As used herein, the third direction DR3 is not a specific direction, and may be a direction in which a virtual center line separating the first emission portion EA1a and the second emission portion EA1b of the first emission area EA1 from each other extends. In other words, the first emission portion EA1a and the second emission portion EA1b of the first emission area EA1 may be portions spaced apart (e.g., separated) from each other based on the third direction DR3. A width of the first emission area EA1 in the third direction DR3 may be less than a width of the first emission area EA1 in a direction different from the third direction DR3. In addition, a fourth direction DR4 may be defined as a direction obliquely crossing the third direction DR3. In an embodiment, an angle between the third direction DR3 and the fourth direction DR4 may be about 45°, but the present invention is not limited thereto. For example, the angle between the third direction DR3 and the fourth direction DR4 may be less than about 45° or greater than about 45°.

In an embodiment, the third direction DR3 in which the virtual center line VCL1 serving as a reference for spacing (e.g., separating) the first emission portion EA1a and the second emission portion EA1b of the first emission area EA1 from each other extends may be an oblique direction of each of the first unit pixel area PXA1 and the second unit pixel area PXA2. In an embodiment, the third direction DR3 may be an oblique direction. In this case, the fourth direction DR4 obliquely crossing the third direction DR3 may be the same as (or parallel to or substantially parallel to) the first direction DR1.

In an embodiment, the first emission area EA1 in the first unit pixel area PXA1 and the first emission area EA1 in the second unit pixel area PXA2 may be separated in different directions. In an embodiment, a direction in which the first emission portion EA1a and the second emission portion EA1b in the first unit pixel area PXA1 are spaced apart from each other may be a direction different from a direction in which the first emission portion EA1a and the second emission portion EA1b in the second unit pixel area PXA2 are spaced apart from each other. For example, the direction in which the first emission portion EA1a and the second emission portion EA1b in the first unit pixel area PXA1 are spaced apart from each other may be perpendicular to or substantially perpendicular to the direction in which the first emission portion EA1a and the second emission portion EA1b in the second unit pixel area PXA2 are spaced apart from each other. For example, in the first unit pixel area PXA1, the first emission portion EA1a and the second emission portion EA1b of the first emission area EA1 may be spaced apart from each other in a first oblique direction, and in the second unit pixel area PXA2, the first emission portion EA1a and the second emission portion EA1b of the first emission area EA1 may be spaced apart from each other in a second oblique direction perpendicular to or substantially perpendicular to the first oblique direction.

In an embodiment, a distance d1 between the first emission portion EA1a of the first emission area EA1 and the second emission portion EA1b of the first emission area EA1 may be less than a distance d2 between the second emission area EA2 and the third emission area EA3.

A width W1 of the first emission area EA1 in the third direction DR3 may be less than a width W2 of the first emission area EA1 in the fourth direction DR4 obliquely crossing the third direction DR3. At least a portion of the first emission area EA1 may be separated based on the third direction DR3 having a relatively smaller width. In other words, the first emission area EA1 may have portions spaced apart (e.g., separated) from each other on opposite sides with respect to the virtual center line VCL1 extending in the third direction DR3. Accordingly, the first emission area EA1 may include the first emission portion EA1a and the second emission portion EA1b spaced apart (e.g., separated) from each other on opposite sides with respect to the virtual center line VCL1 extending in the third direction DR3.

As shown in FIGS. 5 and 6, in an embodiment, in the first unit pixel area PXA1 and the second unit pixel area PXA2, the width W1 of the first emission area EA1 in an oblique direction may be less than the width W2 in the first direction DR1, which is a horizontal direction. Accordingly, the first emission area EA1 may be separated based on an oblique direction having a smaller width. In other words, the first emission area EA1 may include the first emission portion EA1a and the second emission portion EA1b spaced apart from each other in an oblique direction.

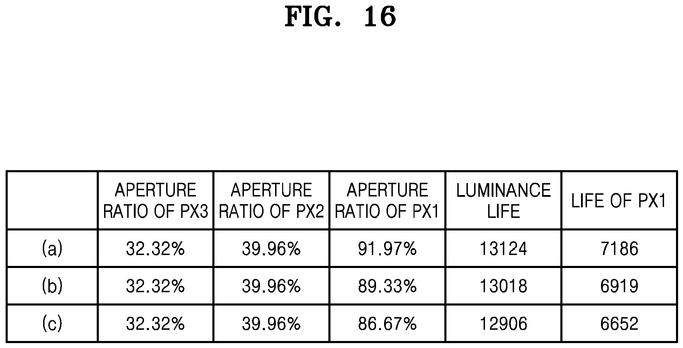

As the first emission area EA1 is separated based on a direction having a smaller width, area loss of the first emission area EA1 may be minimized or reduced. As indicated in the table of FIG. 16, as the first emission area EA1 is separated based on a direction having a smaller width, loss in an aperture ratio may be reduced. In addition, life loss of the display device may be reduced. As used herein, the aperture ratio is defined as a ratio of a portion of a pixel through which light may come out.

In an embodiment, as shown in FIG. 5, the first emission area EA1 may further include a third emission portion EA1c connecting the first emission portion EA1a and the second emission portion EA1b to each other. The third emission portion EA1c may be arranged between the first emission portion EA1a and the second emission portion EA1b. In an embodiment, although it is shown that the number of third emission portions EA1c is one, the present invention is not limited thereto. For example, the number of third emission portions EA1c may be a plurality, and the plurality of third emission portions EA1c may connect opposite edges of the first emission portion EA1a to opposite edges of the second emission portion EA1b, respectively. When the first emission area EA1 includes the third emission portion EA1c connecting the first emission portion EA1a and the second emission portion EA1b to each other, as shown in the table of FIG. 16, loss in an aperture ratio may be minimized or reduced.

The third emission portion EA1c of the first emission area EA1 may connect an edge of the first emission portion EA1a of the first emission area EA1 to an edge of the second emission portion EA1b. In other words, the third emission portion EA1c of the first emission area EA1 may be arranged at an edge of the first emission area EA1, but the present invention is not limited thereto. For example, the third emission portion EA1c of the first emission area EA1 may be arranged at the center of the first emission area EA1. For example, the third emission portion EA1c of the first emission area EA1 may connect the center of the first emission portion EA1a to the center of the second emission portion EA1b.

In an embodiment, the third emission portion EA1c in the first unit pixel area PXA1 may be arranged in a zigzag pattern with the third emission portion EA1c in the second unit pixel area PXA2. In an embodiment, the third emission portion EA1c in the first unit pixel area PXA1 may be arranged to be adjacent to the second emission area EA2 and the third emission area EA3 in the second unit pixel area PXA2. In an embodiment, a distance between the third emission portion EA1c in the second unit pixel area PXA2 and the second emission area EA2 in the second unit pixel area PXA2 may be greater than a distance between the third emission portion EA1c in the first unit pixel area PXA1 and the second emission area EA2 in the second unit pixel area PXA2. An arrangement of the third emission portions EA1c may be variously modified according to various embodiments.

In another embodiment, as shown in FIG. 6, the third emission portion EA1c of the first emission area EA1 connecting the first emission portion EA1a to the second emission portion EA1b of the first emission area EA1 may be omitted. In this case, the first emission area EA1 may include two completely separated sub-emission areas. In other words, the first emission portion EA1a and the second emission portion EA1b of the first emission area EA1 may be a first sub-emission area and a second sub-emission area, respectively. The first emission portion EA1a and the second emission portion EA1b may not be connected to each other.

In an embodiment, the first emission area EA1 may have a shape in which a portion of a polygon is removed in the third direction DR3 having a relatively smaller width. In an embodiment, as shown in FIG. 5, the first emission area EA1 may have a shape recessed in the third direction DR3 having a relatively smaller width. For example, because the first emission area EA1 in the first unit pixel area PXA1 has a smaller width in an oblique direction, the first emission area EA1 may have a recessed shape in the oblique direction. For example, because the first emission area EA1 in the second unit pixel area PXA2 has a smaller width in an oblique direction, the first emission area EA1 may have a recessed shape in the oblique direction. In an embodiment, the first emission area EA1 may have a shape in which a portion of a quadrangle with chamfered vertices is removed.

As shown in FIG. 6, each of the first emission portion EA1a and the second emission portion EA1b of the first emission area EA1 may have a polygonal shape.

In FIGS. 5 and 6, the first emission area EA1 has a polygonal shape. However, the present invention is not limited thereto, and an outline of the first emission area EA1 may include a curved line.

In an embodiment, the second emission area EA2 and the third emission area EA3 may have a rectangular shape. In another embodiment, the second emission area EA2 and the third emission area EA3 may have a closed curve shape. For example, the second emission area EA2 and the third emission area EA3 may have a circular shape, an elliptical shape, or a curved shape.

Each of the emission areas EA may be arranged to correspond to one corresponding pixel electrode 121. The first emission area EA1 may be arranged to correspond to a first pixel electrode 121a, the second emission area EA2 may be arranged to correspond to a second pixel electrode 121b, and the third emission area EA3 may be arranged to correspond to a third pixel electrode 121c. The first emission area EA1 may be disposed on the first pixel electrode 121a, the second emission area EA2 may be disposed on the second pixel electrode 121b, and the third emission area EA3 may be disposed on the third pixel electrode 121c. The first emission portion EA1a and the second emission portion EA1b of the first emission area EA1 may be disposed on one first pixel electrode 121a.

An area of each of the emission areas EA may be less than an area of a corresponding one of the pixel electrode 121. An area of the first emission area EA1 may be less than an area of the first pixel electrode 121a. An area of the second emission area EA2 may be less than an area of the second pixel electrode 121b. An area of the third emission area EA3 may be less than an area of the third pixel electrode 121c.

The first pixel electrode 121a, the second pixel electrode 121b, and the third pixel electrode 121c may have different areas or sizes from each other. In an embodiment, the first pixel electrode 121a may have a larger area than the second pixel electrode 121b. In addition, the first pixel electrode 121a may have a larger area than the third pixel electrode 121c. In an embodiment, the second pixel electrode 121b may have a larger area than the third pixel electrode 121c. In another embodiment, the second pixel electrode 121b may have the same or substantially the same sized area as that of the third pixel electrode 121c.

The first pixel electrode 121a may include a first portion 121aa, a second portion 121ab, and a third portion 121ac. The first portion 121aa and the second portion 121ab of the first pixel electrode 121a may be arranged to be spaced apart from each other, and the third portion 121ac of the first pixel electrode 121a may connect between the first portion 121aa and the second portion 121ab of the first pixel electrode 121a.

The first portion 121aa and the second portion 121ab of the first pixel electrode 121a may be spaced apart from each other in the same direction as the direction in which the first emission portion EA1a and the second emission portion EA1b of the first emission area EA1 are spaced apart from each other. At least a portion of the first pixel electrode 121a may be separated in the same direction as the direction in which the first emission area EA1 is separated. At least a portion of the first pixel electrode 121a may be separated based on the third direction DR3. The first pixel electrode 121a may have portions spaced apart (e.g., separated) from each other on opposite sides with respect to the virtual center line VCL1 extending in the third direction DR3. The first portion 121aa and the second portion 121ab of the first pixel electrode 121a may be portions that are spaced apart (e.g., separated) from each other based on the virtual center line VCL1 extending in the third direction DR3.

In an embodiment, the third direction DR3 in which the virtual center line VCL1 serving as a reference for separating the first portion 121aa and the second portion 121ab of the first pixel electrode 121a extends may be an oblique direction of each of the first unit pixel area PXA1 and the second unit pixel area PXA2. In an embodiment, a direction in which the first portion 121aa and the second portion 121ab of the first pixel electrode 121a arranged within the first unit pixel area PXA1 are spaced apart from each other may be an oblique direction. In an embodiment, a direction in which the first portion 121aa and the second portion 121ab of the first pixel electrode 121a arranged in the second unit pixel area PXA2 are spaced apart from each other may be an oblique direction. In an embodiment, a direction in which the first portion 121aa and the second portion 121ab of the first pixel electrode 121a arranged in the second unit pixel area PXA2 are spaced apart from each other may be a second oblique direction perpendicular to or substantially perpendicular to a first oblique direction in which the first portion 121aa and the second portion 121ab of the first pixel electrode 121a arranged in the first unit pixel area PXA1 are spaced apart from each other. The first emission portion EA1a of the first emission area EA1 may be disposed on the first portion 121aa of the first pixel electrode 121a, and the second emission portion EA1b of the first emission area EA1 may be disposed on the second portion 121ab of the first pixel electrode 121a.

The third portion 121ac of the first pixel electrode 121a may be arranged between the first portion 121aa and the second portion 121ab of the first pixel electrode 121a. In an embodiment, there is one third portion 121ac connecting the first portion 121aa to the second portion 121ab of the first pixel electrode 121a. However, the present invention is not limited thereto. For example, there may be a plurality of third portions 121ac of the first pixel electrode 121a respectively connecting opposite edges of the first portion 121aa to opposite edges of the second portion 121ab.

The third portion 121ac of the first pixel electrode 121a may connect an edge of the first portion 121aa to an edge of the second portion 121ab. In other words, the third portion 121ac of the first pixel electrode 121a may be arranged at an edge of the first pixel electrode 121a, but the present invention is not limited thereto. For example, the third portion 121ac of the first pixel electrode 121a may be arranged at the center of the first pixel electrode 121a. For example, the third portion 121ac of the first pixel electrode 121a may connect the center of the first portion 121aa to the center of the second portion 121ab.

In an embodiment, the third portion 121ac of the first pixel electrode 121a in the first unit pixel area PXA1 may be arranged in a zigzag pattern with the third portion 121ac of the first pixel electrode 121a in the second unit pixel area PXA2. In an embodiment, the third portion 121ac of the first pixel electrode 121a in the first unit pixel area PXA1 may be arranged to be adjacent to the second pixel electrode 121b and the third pixel electrode 121c in the second unit pixel area PXA2. In an embodiment, a distance between the third portion 121ac of the first pixel electrode 121a in the second unit pixel area PXA2 and the second pixel electrode 121b in the second unit pixel area PXA2 may be greater than a distance between the third portion 121ac of the first pixel electrode 121a in the first unit pixel area PXA1 and the second pixel electrode 121b in the second unit pixel area PXA2. An arrangement of the third portion 121ac of the first pixel electrode 121a may be variously modified according to various embodiments.

In an embodiment, as shown in FIG. 5, the third emission portion EA1c of the first emission area EA1 may be disposed on the first pixel electrode 121a. In an embodiment, at least a portion of the third emission portion EA1c of the first emission area EA1 may be disposed on the third portion 121ac of the first pixel electrode 121a. In this case, a pixel-defining layer 119 (e.g., see FIG. 4) may be disposed on at least a portion of the third portion 121ac of the first pixel electrode 121a.

In another embodiment, as shown in FIG. 6, the third emission portion EA1c of the first emission area EA1 may not be disposed on the third portion 121ac of the first pixel electrode 121. In this case, the pixel-defining layer 119 (e.g., see FIG. 4) may be disposed on the entire third portion 121ac of the first pixel electrode 121a.

The first pixel electrode 121a may be separated into two areas, and may have a connection portion connecting the two areas to each other. The first pixel electrode 121a may have a form (e.g., a shape) that is recessed in the third direction DR3 having a relatively smaller width. In FIGS. 5 and 6, because the first pixel electrode 121a has a relatively smaller width in an oblique direction, the first pixel electrode 121a may have a recessed shape in the oblique direction. In an embodiment, the first pixel electrode 121a may have a shape in which a portion of a polygon is removed. In an embodiment, the first pixel electrode 121a may have a shape in which a portion of a quadrangle with chamfered vertices is removed. According to one or more embodiments, at least a portion of the first pixel electrode 121a having a larger area is formed in a separated form (e.g., a separated shape), so that pixel shrinkage due to outgas may be prevented or reduced. In addition, by forming the first pixel electrode 121a to include the third portion 121ac connecting between the first portion 121aa and the second portion 121ab that are spaced apart from each other, the emission area EA may be selectively formed on the third portion 121ac, and thus, life loss of the display device may be minimized or reduced.

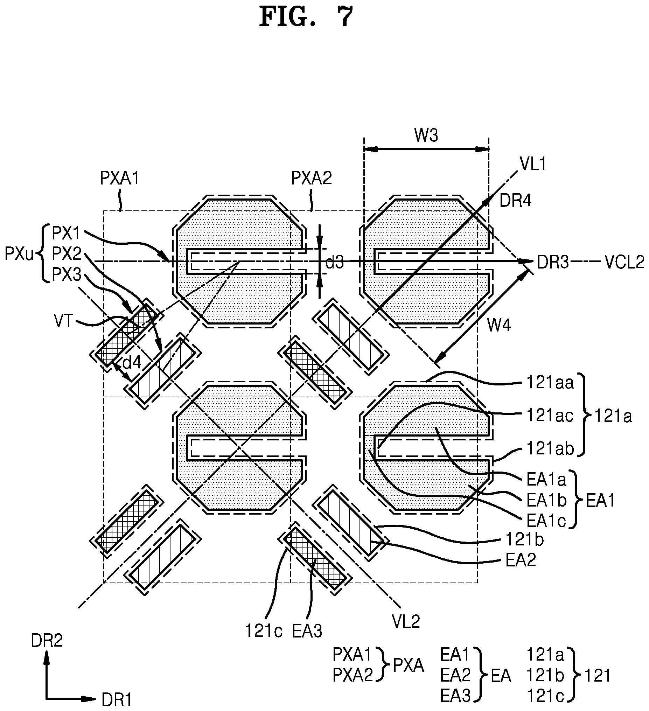

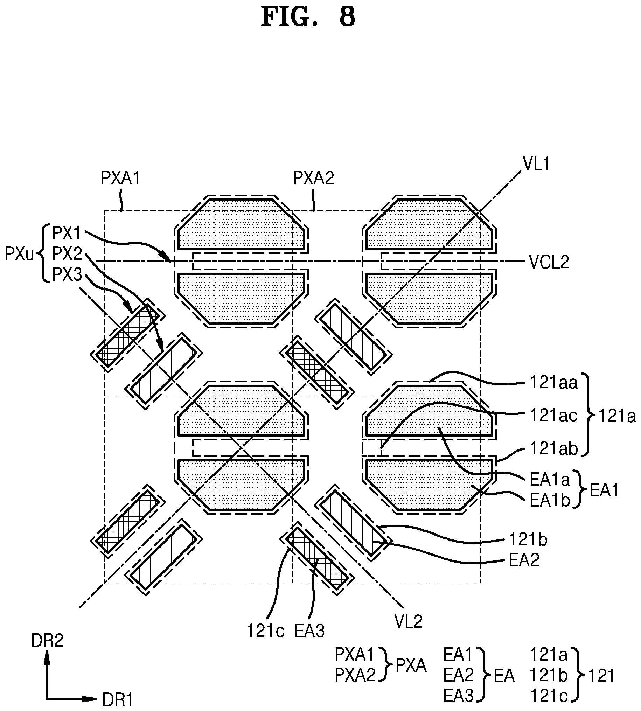

FIGS. 7 and 8 show pixel electrodes 121 and emission areas EA, each corresponding to a first display element of the first pixel PX1, a second display element of the second pixel PX2, and a third display element of the third pixel PX3 arranged in each of the first unit pixel area PXA1 and the second unit pixel area PXA2. Because the pixel arrangements illustrated in FIGS. 7 and 8 are the same or substantially the same as the pixel arrangements illustrated in FIGS. 5 and 6, redundant description thereof may not be repeated, and the differences therebetween may be mainly described hereinafter. The same symbols as those of FIGS. 5 and 6 are used in FIGS. 7 and 8 to denote the same or substantially the same elements as those described above, and modified portions are mainly described hereinafter.

Referring to FIGS. 7 and 8, the third direction DR3 in which the virtual center line VCL2 serving as a reference for separating the first emission portion EA1a and the second emission portion EA1b of the first emission area EA1 from each other extends may be a horizontal direction (e.g., the first direction DR1) or a vertical direction (e.g., the second direction DR2) of each of the first unit pixel area PXA1 and the second unit pixel area PXA2. In an embodiment, the first emission area EA1 may have at least one surface arranged in an oblique direction.

In an embodiment, the third direction DR3 may be a horizontal direction (e.g., the first direction DR1) of each of the first unit pixel area PXA1 and the second unit pixel area PXA2. In another embodiment, the third direction DR3 may be a vertical direction (e.g., the second direction DR2) of each of the first unit pixel area PXA1 and the second unit pixel area PXA2.

In an embodiment, the first emission area EA1 in the first unit pixel area PXA1 and the first emission area EA1 in the second unit pixel area PXA2 may be separated in the same direction. In an embodiment, a direction in which the first emission portion EA1a and the second emission portion EA1b in the first unit pixel area PXA1 are spaced apart from each other may be the same direction as a direction in which the first emission portion EA1a and the second emission portion EA1b in the second unit pixel area PXA2 are spaced apart from each other. In another embodiment, the first emission area EA1 in the first unit pixel area PXA1 and the first emission area EA1 in the second unit pixel area PXA2 may be separated in directions perpendicular to or substantially perpendicular to each other. For example, the first emission portion EA1a and the second emission portion EA1b of the first emission area EA1 in the first unit pixel area PXA1 may be spaced apart from each other in the second direction DR2, and the first emission portion EA1a and the second emission portion EA1b of the first emission area EA1 in the second unit pixel area PXA2 may be spaced apart from each other in the first direction DR1 perpendicular to or substantially perpendicular to the second direction DR2.

In an embodiment, a distance d3 between the first emission portion EA1a of the first emission area EA1 and the second emission portion EA1b of the first emission area EA1 may be less than a distance d4 between the second emission area EA2 and the third emission area EA3.

A width W3 of the first emission area EA1 in the third direction DR3 may be less than a width W4 of the first emission area EA1 in the fourth direction DR4 obliquely crossing the third direction DR3. At least a portion of the first emission area EA1 may be separated based on the third direction DR3 having a relatively smaller width. In other words, the first emission area EA1 may have portions spaced apart (e.g., separated) form each other on opposite sides with respect to the virtual center line VCL2 extending in the third direction DR3. Accordingly, the first emission area EA1 may include the first emission portion EA1a and the second emission portion EA1b, which are spaced apart (e.g., separated) from each other on opposite sides with respect to the virtual center line VCL2 extending in the third direction DR3.

As shown in FIGS. 7 and 8, in the first unit pixel area PXA1 and the second unit pixel area PXA2, the width W3 of the first emission area EA1 in a horizontal direction (e.g., the first direction DR1) may be less than the width W4 in an oblique direction. Accordingly, the first emission area EA1 may be separated based on a horizontal direction (e.g., the first direction DR1) having a smaller width. In other words, the first emission area EA1 may include the first emission portion EA1a and the second emission portion EA1b, which are spaced apart from each other in a vertical direction (e.g., the second direction DR2).

In an embodiment, as shown in FIG. 7, the first emission area EA1 may further include a third emission portion EA1c connecting between the first emission portion EA1a and the second emission portion EA1b. The third emission portion EA1c may be arranged between the first emission portion EA1a and the second emission portion EA1b. In an embodiment, the number of third emission portions EA1c connecting the first emission portion EA1a to the second emission portion EA1b is one, but the present invention is not limited thereto. For example, the number of third emission portions EA1c respectively connecting opposite edges of the first emission portion EA1a to opposite edges of the second emission portion EA1b may a plurality.

The third emission portion EA1c of the first emission area EA1 may connect an edge of the first emission portion EA1a of the first emission area EA1 to an edge of the second emission portion EA1b. In other words, the third emission portion EA1c of the first emission area EA1 may be arranged at an edge of the first emission area EA1, but the present invention is not limited thereto. For example, the third emission portion EA1c of the first emission area EA1 may be arranged at the center of the first emission area EA1. For example, the third emission portion EA1c of the first emission area EA1 may connect the center of the first emission portion EA1a to the center of the second emission portion EA1b.

The third emission portion EA1c in the first unit pixel area PXA1 and the third emission portion EA1c in the second unit pixel area PXA2 are arranged at corresponding locations of the first unit pixel area PXA1 and the second unit pixel area PXA2 respectively, but are not limited thereto. For example, the third emission portion EA1c in the first unit pixel area PXA1 and the third emission portion EA1c in the second unit pixel area PXA2 may be arranged symmetrically or substantially symmetrically to each other. An arrangement of the third emission portion EA1c may be variously modified according to various embodiments.

In another embodiment, as shown in FIG. 8, the third emission portion EA1c of the first emission area EA1 connecting the first emission portion EA1a to the second emission portion EA1b of the first emission area EA1 may be omitted. In this case, the first emission area EA1 may include two completely separated sub-emission areas. In other words, the first emission portion EA1a and the second emission portion EA1b of the first emission area EA1 may be a first sub-emission area and a second sub-emission area, respectively. The first emission portion EA1a and the second emission portion EA1b may not be connected to each other.

In an embodiment, the first emission area EA1 may have a shape in which a portion of a polygon is removed in the third direction DR3 having a relatively smaller width. In an embodiment, as shown in FIG. 7, the first emission area EA1 may have a shape recessed in the third direction DR3 having a relatively smaller width. In FIG. 7, because the first emission area EA1 has the width W3 in a horizontal direction (e.g., the first direction DR1), the first emission area EA1 may have a recessed shape in the first direction DR1. As shown in FIG. 8, each of the first emission portion EA1a and the second emission portion EA1b of the first emission area EA1 may be a polygon. In FIGS. 7 and 8, the first emission area EA1 is a polygon. However, the present invention is not limited thereto, and the first emission area EA1 may have a curved outline. In an embodiment, the first emission area EA1 may have a shape in which a portion of a quadrangle with chamfered vertices is removed.

Each of the emission areas EA may be arranged to correspond to one corresponding pixel electrode 121. The first emission area EA1 may be arranged to correspond to the first pixel electrode 121a, the second emission area EA2 may be arranged to correspond to the second pixel electrode 121b, and the third emission area EA3 may be arranged to correspond to the third pixel electrode 121c. The first emission area EA1 may be disposed on the first pixel electrode 121a, the second emission rea EA2 may be disposed on the second pixel electrode 121b, and the third emission area EA3 may be disposed on the third pixel electrode 121c. The first emission portion EA1a and the second emission portion EA1b of the first emission area EA1 may be disposed on one first pixel electrode 121a.

The first pixel electrode 121a may include a first portion 121aa, a second portion 121ab, and a third portion 121ac. The first portion 121aa and the second portion 121ab of the first pixel electrode 121a may be arranged to be spaced apart from each other, and the third portion 121ac of the first pixel electrode 121a may connect between the first portion 121aa and the second portion 121ab of the first pixel electrode 121a.

The first portion 121aa and the second portion 121ab of the first pixel electrode 121a may be spaced apart from each other in the same direction as a direction in which the first emission portion EA1a and the second emission portion EA1b of the first emission area EA1 are spaced apart from each other. At least a portion of the first pixel electrode 121a may be separated in the same direction as a direction in which the first emission area EA1 is separated. At least a portion of the first pixel electrode 121a may be separated based on the virtual center line VCL2 extending in the third direction DR3. The first pixel electrode 121a may have portions spaced apart (e.g., separated) from each other on opposite sides with respect to the virtual center line VCL2 extending in the third direction DR3. The first portion 121aa and the second portion 121ab of the first pixel electrode 121 may be portions spaced apart (e.g., separated) from each other based on the virtual center line VCL2 extending in the third direction DR3.

In an embodiment, the first pixel electrode 121a in the first unit pixel area PXA1 and the first pixel electrode 121a in the second unit pixel area PXA2 may be separated in the same direction. In an embodiment, a direction in which the first portion 121aa and the second portion 121ab of the first pixel electrode 121a in the first unit pixel area PXA1 are spaced apart from each other may be the same direction as a direction in which the first portion 121aa and the second portion 121ab of the first pixel electrode 121a in the second unit pixel area PXA2 are spaced apart from each other. In an embodiment, the third direction DR3 in which the virtual center line VCL2 separating the first portion 121aa and the second portion 121ab of the first pixel electrode 121a from each other arranged in the first unit pixel area PXA1 extends may be a horizontal direction (e.g., the first direction DR1). In an embodiment, the third direction DR3 in which the virtual center line VCL2 separating the first portion 121aa and the second portion 121ab of the first pixel electrode 121a from each other arranged in the second unit pixel area PXA2 extends may also be a horizontal direction (e.g., the first direction DR1).

In another embodiment, the first pixel electrode 121a in the first unit pixel area PXA1 and the first pixel electrode 121a in the second unit pixel area PXA2 may be separated in directions perpendicular to or substantially perpendicular to each other. For example, the first portion 121aa and the second portion 121ab of the first pixel electrode 121a in the first unit pixel area PXA1 may be spaced apart from each other in the second direction DR2, and the first portion 121aa and the second portion 121ab of the first pixel electrode 121a in the second unit pixel area PXA2 may be spaced apart from each other in the first direction DR1 perpendicular to or substantially perpendicular to the second direction DR2.

In an embodiment, the third portion 121ac of the first pixel electrode 121a in the first unit pixel area PXA1 may be arranged parallel to or substantially parallel to the third portion 121ac of the first pixel electrode 121a in the second unit pixel area PXA2. The third portion 121ac of the first pixel electrode 121a in the first unit pixel area PXA1 and the third portion 121ac of the first pixel electrode 121a in the second unit pixel area PXA2 may be arranged at corresponding locations of the first unit pixel area PXA1 and the second unit pixel area PXA2 respectively, but the present invention is not limited thereto. For example, the third portion 121ac of the first pixel electrode 121a in the first unit pixel area PXA1 and the third portion 121ac of the first pixel electrode 121a in the second unit pixel area PXA2 may be arranged symmetrically or substantially symmetrically to each other. An arrangement of the third portion 121ac of the first pixel electrode 121a may be variously modified according to various embodiments.

In an embodiment, the third direction DR3 in which the virtual center line VCL2 separating the first portion 121aa and the second portion 121ab of the first pixel electrode 121a from each other arranged in the first unit pixel area PXA1 and the second unit pixel area PXA2 may be a horizontal direction (e.g., the first direction DR1).

In an embodiment, as shown in FIG. 7, the third emission portion EA1c of the first emission area EA1 may be disposed on the first pixel electrode 121a. In an embodiment, at least a portion of the third emission portion EA1c of the first emission area EA1 may be disposed on the third portion 121ac of the first pixel electrode 121. In this case, a pixel-defining layer 119 (e.g., see FIG. 4) may be disposed on a portion of the third portion 121ac of the first pixel electrode 121a.

In another embodiment, as shown in FIG. 8, the third emission portion EA1c of the first emission area EA1 may not be disposed on the third portion 121ac of the first pixel electrode 121a. In this case, the pixel-defining layer 119 (e.g., see FIG. 4) may be disposed on the entire third portion 121ac of the first pixel electrode 121a.

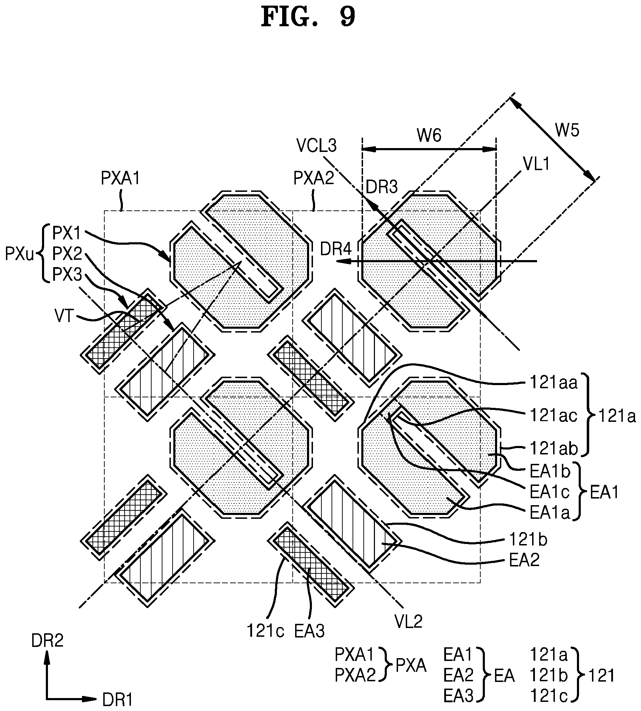

FIG. 9 shows the pixel electrodes 121 and the emission areas EA corresponding to a first display element of the first pixel PX1, a second display element of the second pixel PX2, and a third display element of the third pixel PX3 arranged in each of the first unit pixel area PXA1 and the second unit pixel area PXA2. Because the pixel arrangement illustrated in FIG. 9 is the same or substantially the same as the pixel arrangements illustrated in FIGS. 5 and 6, redundant description thereof may not be repeated and the difference therebetween may be mainly described hereinafter. The same symbols of FIGS. 5 and 6 are used in FIG. 9 to denote the same or substantially the same elements as those described above, and modified portions are mainly described in more detail below.

Referring to FIG. 9, the first emission area EA1 in the first unit pixel area PXA1 and the first emission area EA1 in the second unit pixel area PXA2 may be separated in the same direction. The first pixel electrode 121a in the first unit pixel area PXA1 and the first pixel electrode 121a in the second unit pixel area PXA2 may be separated in the same direction. The first emission area EA1 may have at least one surface arranged in an oblique direction.

In an embodiment, a direction in which the first emission portion EA1a and the second emission portion EA1b in the first unit pixel area PXA1 are spaced apart from each other may be the same direction as a direction in which the first emission portion EA1a and the second emission portion EA1b in the second unit pixel area PXA2 are spaced apart from each other.

The third emission portion EA1c of the first emission area EA1 may connect an edge of the first emission portion EA1a to an edge of the second emission portion EA1b of the first emission area EA1. In other words, the third emission portion EA1c of the first emission area EA1 may be arranged at an edge of the first emission area EA1, but the present invention is not limited thereto. For example, the third emission portion EA1c of the first emission area EA1 may be arranged at the center of the first emission area EA1. For example, the third emission portion EA1c of the first emission area EA1 may connect the center of the first emission portion EA1a to the center of the second emission portion EA1b. In an embodiment, the third emission portion EA1c in the first unit pixel area PXA1 may be arranged in a zigzag pattern with the third emission portion EA1c in the second unit pixel area PXA2.

A width W5 of the first emission area EA1 in the third direction DR3 may be less than a width W6 in the fourth direction DR4 obliquely crossing the third direction DR3. At least a portion of the first emission area EA1 may be separated based on the third direction DR3 having a relatively smaller width. In other words, the first emission area EA1 may have portions that are spaced apart (e.g., separated) from each other at opposite sides with respect to a virtual center line VCL3 extending in the third direction DR3. Accordingly, the first emission area EA1 may include the first emission portion EA1a and the second emission portion EA1b that are spaced apart (e.g., separated) from each other based on the virtual center line VCL3 extending in the third direction DR3.

In an embodiment, in the first unit pixel area PXA1 and the second unit pixel area PXA2, the width W5 of the first emission area EA1 in an oblique direction may be less than the width W6 in a horizontal direction (e.g., the first direction DR1). Accordingly, in an embodiment, the first emission area EA1 may be separated based on an oblique direction having a smaller width. In other words, the first emission area EA1 may include the first emission portion EA1a and the second emission portion EA1b that are spaced apart from each other in an oblique direction.

The first portion 121aa and the second portion 121ab of the first pixel electrode 121a may be spaced apart from each other in the same direction as a direction in which the first emission portion EA1a and the second emission portion EA1b of the first emission area EA1 are spaced apart from each other. In other words, the first portion 121aa and the second portion 121ab of the first pixel electrode 121a may be spaced apart from each other in the third direction DR3. At least a portion of the first pixel electrode 121a may be separated in the same direction as a direction in which the first emission area EA1 is separated. At least a portion of the first pixel electrode 121a may be separated based on the virtual center line VCL extending in the third direction DR3. The first pixel electrode 121a may have portions that are spaced apart (e.g., separated) from each other at opposite sides with respect to the virtual center line VCL extending in the third direction DR3. The first portion 121aa and the second portion 121ab of the first pixel electrode 121 may be portions that are spaced apart (e.g., separated) from each other based on the virtual center line VCL3 extending in the third direction DR3.

In an embodiment, the first pixel electrode 121a in the first unit pixel area PXA1 and the first pixel electrode 121a in the second unit pixel area PXA2 may be separated in the same direction. In an embodiment, a direction in which the first portion 121aa and the second portion 121ab of the first pixel electrode 121a in the first unit pixel area PXA1 are spaced apart from each other may be the same direction as a direction in which the first portion 121aa and the second portion 121ab of the first pixel electrode 121a in the second unit pixel area PXA2 are spaced apart from each other. For example, as shown in FIG. 9, the first portion 121aa and the second portion 121 ab of the first pixel electrode 121a in the first unit pixel area PXA1 may be spaced apart from each other in an oblique direction, and the first portion 121aa and the second portion 121ab of the first pixel electrode 121a in the second unit pixel area PXA2 may also be spaced apart from each other in an oblique direction.

In the embodiment of FIG. 9, as described above and illustrated in FIGS. 6 and 8, a structure in which the third emission portion EA1c of the first emission area EA1 is not disposed on the third portion 121ac of the first pixel electrode 121a may be applied in the same or substantially the same manner. In the embodiment of FIG. 9, as described above and illustrated in FIGS. 7 and 8, a separation direction of the first emission area EA1 may be a vertical direction of the first and second unit pixel areas PXA1 and PXA2.

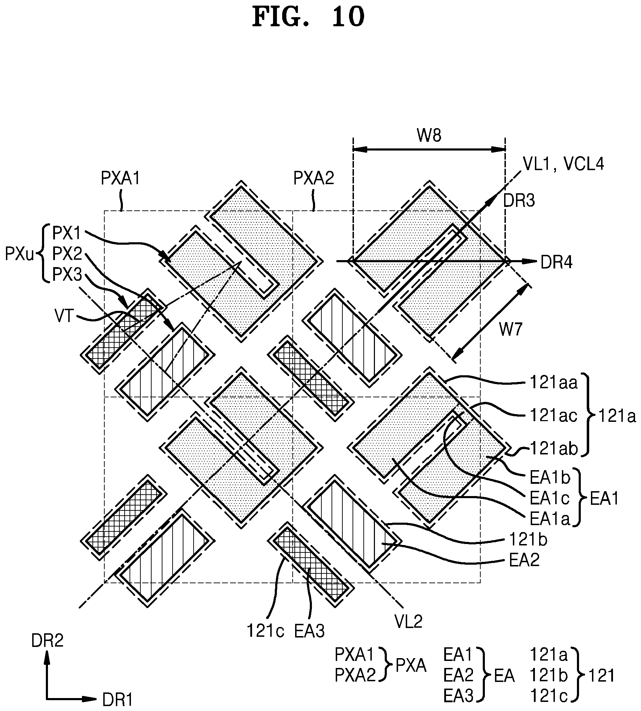

FIG. 10 shows the pixel electrodes 121 and the emission areas EA corresponding to a first display element of the first pixel PX1, a second display element of the second pixel PX2, and a third display element of the third pixel PX3 arranged in each of the first unit pixel area PXA1 and the second unit pixel area PXA2. Because the pixel arrangement illustrated in FIG. 10 is the same or substantially the same as the pixel arrangements described above with reference to FIGS. 5 and 6, redundant description thereof may not be repeated and the differences therebetween may be mainly described in more detail hereinafter. The same symbols as those of FIGS. 5 and 6 are used in FIG. 10 to illustrate the same or substantially the same components, and modified portions may be mainly described in more detail below.

Referring to FIG. 10, the first emission area EA1 may have a shape in which a portion of a quadrangle is removed.

In an embodiment, the first emission area EA1 may have a shape in which a portion of a quadrangle is removed in the third direction DR3 having a relatively smaller width. In an embodiment, the first emission area EA1 may have a quadrangle shape recessed in the third direction DR3 having a relatively smaller width. Because the first emission area EA1 in the first unit pixel area PXA1 has a smaller width W7 in an oblique direction, the first emission area EA1 may have a recessed quadrangle shape in the oblique direction. Because the first emission area EA1 in the second unit pixel area PXA2 has a smaller width in an oblique direction, the first emission area EA1 may have a recessed quadrangular shape in the oblique direction. The first emission area EA1 may have at least one surface arranged in an oblique direction. In an embodiment, the first emission area EA1 may have four surfaces arranged in an oblique direction.

The width W7 of the first emission area EA1 in the third direction DR3 may be less than a width W8 in the fourth direction DR4 obliquely crossing the third direction DR3. At least a portion of the first emission area EA1 may be separated based on the third direction DR3 having a relatively smaller width. In other words, the first emission area EA1 may have portions that are spaced apart (e.g., separated) from each other at opposite sides with respect to a virtual center line VCL4 extending in the third direction DR3. Accordingly, the first emission area EA1 may include the first emission portion EA1a and the second emission portion EA1b, which are spaced apart (e.g., separated) from each other at opposite sides with respect to the virtual center line VCL4 in the third direction DR3.

In an embodiment, the width W7 of the first emission area EA1 in an oblique direction in the second pixel area PXA2 may be less than the width W8 in a horizontal direction (e.g., the first direction DR1). In an embodiment, in the first unit pixel area PXA1, a width of the first emission area EA1 in an oblique direction may be less than a width in a horizontal direction (e.g., the first direction DR1). Accordingly, in an embodiment, the first emission area EA1 may be separated based on an oblique direction having a smaller width. In other words, the first emission area EA1 may include the first emission portion EA1a and the second emission portion EA1b, which are spaced apart (e.g., separated) from each other in an oblique direction.

In the embodiment of FIG. 10, a structure in which the third emission portion EA1c of the first emission area EA1 is not disposed on the third portion 121ac of the first pixel electrode 121, as described above and illustrated in FIGS. 6 and 8, may be applied in the same or substantially the same manner. In the embodiment of FIG. 10, as described above and illustrated in FIGS. 7 and 8, a separation direction of the first emission area EA1 may be a vertical direction of the first and second unit pixel areas PXA1 and PXA2. In the embodiment of FIG. 10, as described above and illustrated in FIG. 9, separation directions of the first emission areas EA1 of the first and second unit pixel areas PXA1 and PXA2 may be the same as each other.

Hereinafter, some additional embodiments of the present invention are described in more detail, and thus, redundant description may not be repeated and the differences may be mainly described in more detail.

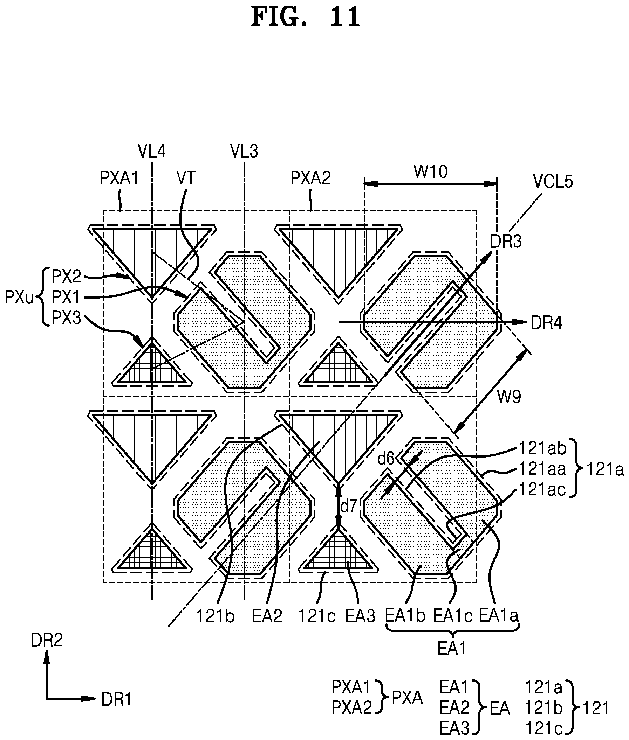

FIGS. 11 through 15 are diagrams illustrating various arrangements of pixels according to one or more embodiments. FIGS. 11 through 15 are plan views illustrating the first unit pixel area PXA1 and the second unit pixel area PXA2, each including the first pixel PX1, the second pixel PX2, and the third pixel PX3 of a display device.

FIGS. 11 through 15 show the pixel electrodes 121 and the emission areas EA corresponding to the first display element of the first pixel PX1, the second display element of the second pixel PX2, and the third display element of the third pixel PX3 arranged in each of the first unit pixel area PXA1 and the second unit pixel area PXA2.

Referring to FIGS. 11 through 15, centers of the first emission area EA1 of the first pixel PX1 in the unit pixel area PXA, the second emission area EA2 of the second pixel PX2, and the third emission area EA3 of the third pixel PX3 may be located at vertices of a virtual triangle VT. In the display area DA, the first unit pixel area PXA1 and the second unit pixel area PXA2 may be alternately located with each other in the first direction DR1 and the second direction DR2. Each of the area of the second display element and the area of the third display element may be less than the area of the first display element.

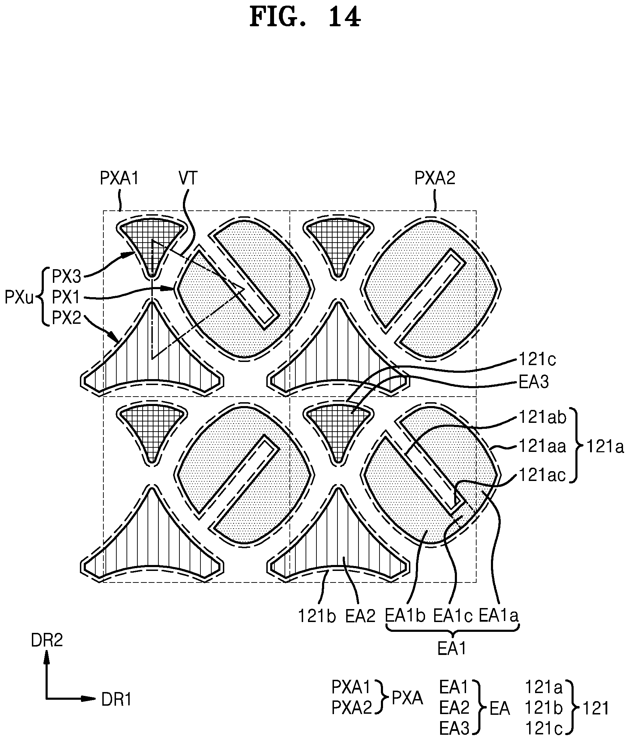

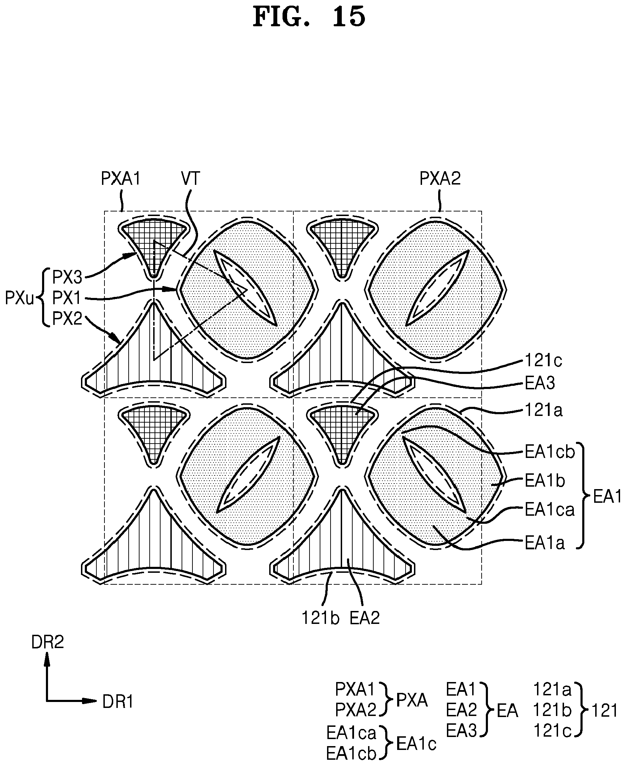

In an embodiment, in the first unit pixel area PXA1 and the second unit pixel area PXA2, the second emission area EA2 of the second pixel PX2 and the third emission area EA3 of the third pixel PX3 may be arranged to be adjacent to each other in the second direction DR2, and the first emission area EA1 of the first pixel PX1 may be arranged to be adjacent to each of the second emission area EA2 of the second pixel PX2 and the third emission area EA3 of the third pixel PX3 in the first direction DR1. Accordingly, the first emission area EA1 may be repeatedly arranged in the second direction DR2 along a third virtual straight line VL3, and the second emission area EA2 and the third emission area EA3 may be alternately arranged with each other in the second direction DR2 along a fourth virtual straight line VL4. A vertical relationship in the second direction DR2 of the second emission area EA2 and the third emission area EA3 arranged in the first unit pixel area PXA1 and the second unit pixel area PXA2 may be modified according to one or more embodiments. For example, as shown in FIGS. 11 through 13, the second emission area EA2 may be disposed above the third emission area EA3 in a plan view, and as shown in FIGS. 14 and 15, the third emission area EA3 may be disposed above the second emission area EA2 in a plan view. In addition, at least one surface of each of the second emission area EA2 and the third emission area EA3 may be located in an oblique direction.

The first emission area EA1 may have at least one surface arranged in an oblique direction. The first emission area EA1 may include the first emission portion EA1a and the second emission portion EA1b spaced apart from each other. At least a portion of the first emission area EA1 may be separated based on a virtual center line VCL5 extending in the third direction DR3. In an embodiment, the first emission portion EA1a and the second emission portion EA1b of the first emission area EA1 may be portions that are spaced apart (e.g., separated) from each other based on the virtual center line VCL5 extending in the third direction DR3.

In an embodiment, the third direction DR3 in which the virtual center line VCL5 extends, may be an oblique direction of each of the first unit pixel area PXA1 and the second unit pixel area PXA2. The virtual center line VCL5 may serve as a reference for spacing apart (e.g., separating) the first emission portion EA1a and the second emission portion EA1b of the first emission area EA1 from each other. In an embodiment, a direction in which the first emission portion EA1a and the second emission portion EA1b of the first emission area EA1 are spaced apart from each other may be an oblique direction of each of the first unit pixel area PXA1 and the second unit pixel area PXA2. In an embodiment, the third direction DR3 may be an oblique direction. In this case, the fourth direction DR4 crossing the third direction DR3 in an oblique direction may be the same as (e.g., parallel to or substantially parallel to) the first direction DR1.

In an embodiment, the first emission area EA1 in the first unit pixel area PXA1 and the first emission area EA1 in the second unit pixel area PXA2 may be separated in different directions from each other. In an embodiment, a direction in which the first emission portion EA1a and the second emission portion EA1b in the first unit pixel area PXA1 are spaced apart from each other may be different from a direction in which the first emission portion EA1a and the second emission portion EA1b in the second unit pixel area PXA2 are spaced apart from each other. For example, a direction in which the first emission portion EA1a and the second emission portion EA1b of the first unit pixel area PXA1 are spaced apart from each other may be a vertical direction of a direction in which the first emission portion EA1a and the second emission portion EA1b in the second unit pixel area PXA2 are spaced apart from each other. For example, in the first unit pixel area PXA1, the first emission portion EA1a and the second emission portion EA1b of the first emission area EA1 may be spaced apart from each other in a first oblique direction, and in the second unit pixel area PXA2, the first emission portion EA1a and the second emission portion EA1b of the first emission area EA1 may be spaced apart from each other in a second oblique direction that is perpendicular to or substantially perpendicular to the first oblique direction. In another embodiment, the first emission area EA1 in the first unit pixel area PXA1 and the first emission area EA1 in the second unit pixel area PXA2 may be separated in the same direction.

In an embodiment, a distance d6 between the first emission portion EA1a of the first emission area EA1 and the second emission portion EA1b of the first emission area EA1 may be less than a distance d7 between the second emission area EA2 and the third emission area EA3.

A width W9 of the first emission area EA1 in the third direction DR3 may be less than a width W10 in the fourth direction DR4 obliquely crossing the third direction DR3. At least a portion of the first emission area EA1 may be separated in the third direction DR3 having a relatively smaller width. In other words, the first emission area EA1 may have portions that are spaced apart (e.g., separated) from each other at opposite sides with respect to the virtual center line VCL5 extending in the third direction DR3.

In an embodiment, in the first unit pixel area PXA1 and the second unit pixel area PXA2, the width W9 of the first emission area EA1 in an oblique direction may be less than the width W10 in the first direction DR1, which may be a horizontal direction. Accordingly, the first emission area EA1 may be separated based on an oblique direction having a smaller width. In other words, the first emission area EA1 may include the first emission portion EA1a and the second emission portion EA1b that are spaced apart from each other in an oblique direction.

In an embodiment, the first emission area EA1 may further include the third emission portion EA1c connecting between the first emission portion EA1a and the second emission portion EA1b. In another embodiment, the third emission portion EA1c of the first emission area EA1 connecting the first emission portion EA1a to the second emission portion EA1b of the first emission area EA1 may be omitted as needed or desired. In FIGS. 11 through 14, one third emission portion EA1c connects the first emission portion EA1a and the second emission portion EA1b together. However, the present invention is not limited thereto. For example, a plurality of third emission portions EA1c may connect opposite edges of the first emission portion EA1a to opposite edges of the second emission portion EA1b, respectively. As shown in FIG. 15, the third emission portion EA1c may include a 3-1^{st} emission portion EA1ca and a 3-2^{nd} emission portion EA1cb, which connect the opposite edges to each other.

In an embodiment, the third emission portion EA1c in the first unit pixel area PXA1 may be arranged in a zigzag pattern with the third emission portion EA1c in the second unit pixel area PXA2. The third emission portion EA1c in the first unit pixel area PXA1 may be arranged to be adjacent to the third emission area EA3 of the second pixel area PXA2, and the third emission portion EA1c in the second unit pixel area PXA2 may be arranged to be adjacent to the second emission area EA2 of the first unit pixel area PXA1. However, the arrangement of the third emission portion EA1c is not limited thereto, and may be variously modified according to one or more embodiments. For example, the third emission portion EA1c of the second unit pixel area PXA2 may be arranged to be adjacent to the third emission area EA3 in the second unit pixel area PXA2.

In an embodiment, the first emission area EA1 may have a shape in which a portion of a polygon is removed in the third direction DR3 having a relatively smaller width. In an embodiment, the first emission area EA1 may have a recess portion recessed in the third direction DR3 having a relatively smaller width. For example, because the first emission area EA1 in the first unit pixel area PXA1 has a smaller width in an oblique direction, the first emission area EA1 may have a recessed shape in the oblique direction. For example, because the first emission area EA1 in the second unit pixel area PXA2 has a smaller width in an oblique direction, the first emission area EA1 may have a recessed shape in the oblique direction. In an embodiment, the first emission area EA1 may have a shape with chamfered vertices or a shape in which a portion of a quadrangle is removed.

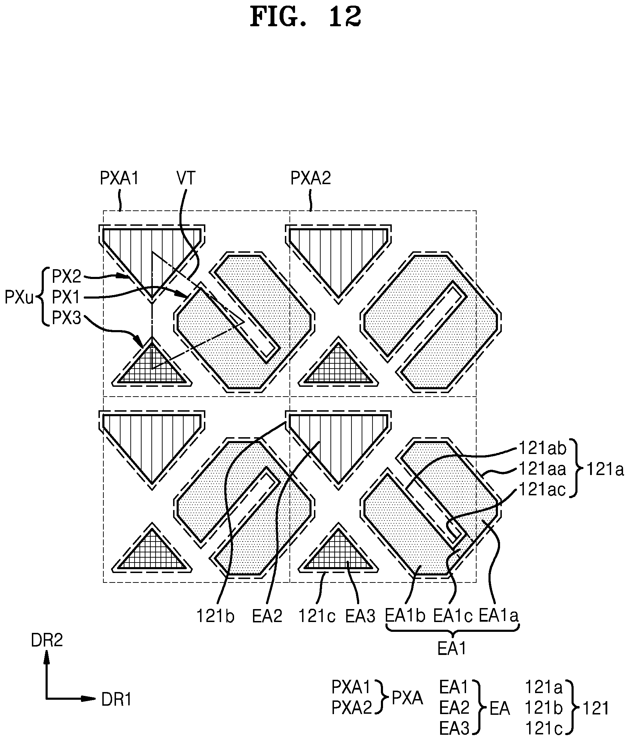

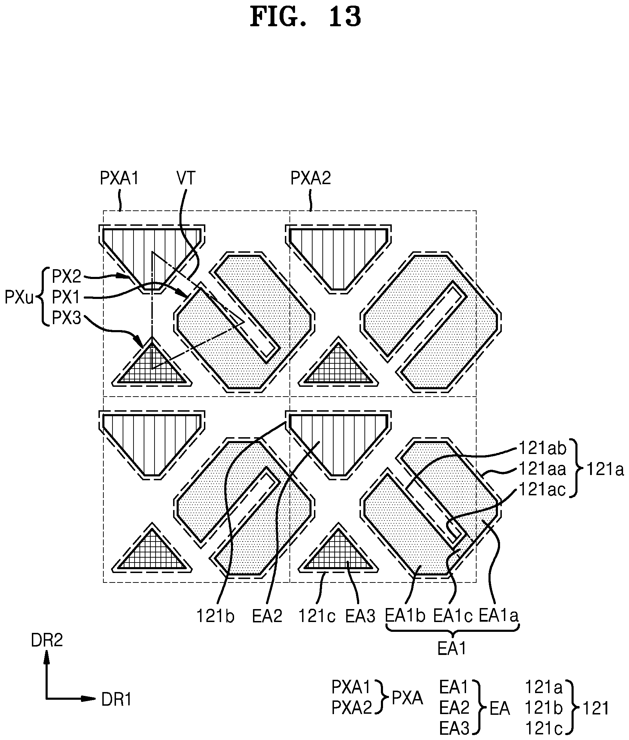

Each of the second emission area EA2 and the third emission area EA3 may have a triangular, pentagonal, and/or hexagonal shape. In an embodiment, as shown in FIG. 11, each of the second emission area EA2 and the third emission area EA3 may have a triangular shape. In an embodiment, as shown in FIG. 12, the second emission area EA2 may have a shape in which some vertices thereof are chamfered, or a pentagonal shape. In FIG. 12, the second emission area EA2 has a pentagonal shape, and the third emission area EA3 has a triangular shape. However, the present invention is not limited thereto. For example, similar to the second emission area EA2, the third emission area EA3 may have a shape in which some vertices thereof are chamfered, a pentagonal shape, or a hexagonal shape. In an embodiment, as shown in FIG. 13, the second emission area EA2 may have a shape in which some vertices thereof are chamfered, or a hexagonal shape. In FIG. 13, the second emission area EA2 has a hexagonal shape, and the third emission area EA3 has a triangular shape. However, the present invention is not limited thereto. For example, similar to the second emission area EA2, the third emission area EA3 may have a shape in which some vertices thereof are chamfered, a pentagonal shape, or a hexagonal shape.

In another embodiment, as shown in FIGS. 14 and 15, each of the second emission area EA2 and the third emission area EA3 may have a shape in which at least one surface thereof includes a curved line.

In the embodiments of FIGS. 14 and 15, a distance between sides of the first emission area EA1 and the second emission area EA2 facing each other may be constant or substantially constant. In other words, the distance between the sides of the first emission area EA1 and the second emission area EA2 facing each other may be the same or substantially the same in a center area and an edge area. A distance between sides of the first emission area EA1 and the third emission area EA3 facing each other may be constant or substantially constant. In another embodiment, the distance between the sides of the first emission area EA1 and the second emission area EA2 facing each other may not be constant, and the distance between the sides of the first emission area EA1 and the third emission area EA3 facing each other may not be constant. For example, the distance between the sides of the first emission area EA1 and the second emission area EA2 facing each other in the center area may be less than or greater than in the edge area. For example, the distance between the sides of the first emission area EA1 and the third emission area EA3 facing each other in the center area may be less than or greater than in the edge area.

The first portion 121aa and the second portion 121ab of the first pixel electrode 121a may be spaced apart from each other in the same direction as a direction in which the first emission portion EA1a and the second emission portion EA1b of the first emission area EA1 are spaced apart from each other. At least a portion of the first pixel electrode 121a may be separated in the same direction as a direction in which the first emission area EA1 is separated. At least a portion of the first pixel electrode 121a may be separated in the third direction DR3.

In an embodiment, the third direction DR3 in which the virtual center line VCL5 extends may be an oblique direction of each of the first unit pixel area PXA1 and the second unit pixel area PXA2. The virtual center line VCL5 may serve as a reference line for spacing apart (e.g., separating) the first portion 121aa and the second portion 121ab of the first pixel electrode 121a from each other. In an embodiment, a direction in which the first portion 121aa and the second portion 121ab of the first pixel electrode 121a arranged in the first unit pixel area PXA1 are spaced apart from each other may be an oblique direction. In an embodiment, a direction in which the first portion 121aa and the second portion 121ab of the first pixel electrode 121a arranged in the second unit pixel area PXA2 are spaced apart from each other may be an oblique direction. In an embodiment, a direction in which the first portion 121aa and the second portion 121ab of the first pixel electrode 121a arranged in the second unit pixel area PXA2 are spaced apart from each other may be a second oblique direction perpendicular to or substantially perpendicular to a first oblique direction in which the first portion 121aa and the second portion 121ab of the first pixel electrode 121a arranged in the first unit pixel area PXA1 are spaced apart from each other.

In an embodiment, the third portion 121ac of the first pixel electrode 121a in the first unit pixel area PXA1 may be arranged in a zigzag pattern with the third portion 121ac of the first pixel electrode 121a in the second unit pixel area PXA2. The third portion 121ac of the first pixel electrode 121a in the first unit pixel area PXA1 may be arranged adjacent to the third pixel electrode 121c of the second unit pixel area PXA2, and the third portion 121ac of the first pixel electrode 121a in the second unit pixel area PXA2 may be arranged adjacent to the second pixel electrode 121b of the first unit pixel area PXA1. However, an arrangement of the third portion 121ac of the first pixel electrode 121a is not limited thereto, and may be variously modified according to one or more embodiments. For example, the third portion 121ac of the first pixel electrode 121a of the second unit pixel area PXA2 may be arranged adjacent to the third pixel electrode 121c in the second unit pixel area PXA2.

In an embodiment, as shown in FIGS. 11 through 14, the third emission portion EA1c of the first emission area EA1 may be disposed on the first pixel electrode 121a. In an embodiment, at least a portion of the third emission portion EA1c of the first emission area EA1 may be disposed on the third portion 121ac of the first pixel electrode 121. In this case, the pixel-defining layer 119 (e.g., see FIG. 4) may be disposed on a portion of the third portion 121ac of the first pixel electrode 121. In another embodiment, the third emission portion EA1c of the first emission area EA1 may not be disposed on the third portion 121ac of the first pixel electrode 121. In this case, the pixel-defining layer 119 (e.g., see FIG. 4) may be disposed on the entire third portion 121ac of the first pixel electrode 121.

The first pixel electrode 121a may be separated into two areas, and may have a connection portion connecting the two areas together. The first pixel electrode 121a may have a recessed shape in the third direction DR3 having a relatively smaller width. In FIG. 11, because the first pixel electrode 121a has a relatively smaller width in an oblique direction, the first pixel electrode 121a may have a recessed shape in the oblique direction. In an embodiment, the first pixel electrode 121a may have a shape in which a portion of a polygon is removed. In an embodiment, the first pixel electrode 121a may have a shape in which a portion of a quadrangle with chamfered vertices is removed.

FIG. 16 is a table showing aperture ratios and life according to division directions of emission areas of display elements. In FIG. 16, an Example (a) has the same or substantially the same structure as the embodiment illustrated in FIG. 5, an Example (b) has the same or substantially the same structure as the embodiment illustrated in FIG. 6, and an Example (c) has a structure in which a division direction is a horizontal direction rather than an oblique direction in the embodiment illustrated in FIG. 5.

Referring to FIG. 16, compared to the Examples (b) and (c), the first pixel PX1 of the Example (a) has the largest aperture ratio, and luminance life and pixel life are also large. Compared to the Example (c), the first pixel PX1 of the Example (b) has a larger aperture ratio, and luminance life and pixel life are also large.

In the embodiment of FIG. 5, the first emission area EA1 is separated in an oblique direction of which the width is relatively smaller than a width in a horizontal direction, and an experimental result as that in the Example (a) of FIG. 16 is shown. As described above, when the first emission area EA1 of the first pixel PX1 is separated into two areas based on a direction having a smaller width, it may have a larger aperture ratio and longer life than a case in which the first emission area EA1 is separated based on a direction having a relatively larger width.

As shown in FIG. 5, when the third emission portion EA1c connecting the first emission portion EA1a to the second emission portion EA1b of the first emission area EA1 is present, it may be confirmed that an aperture ratio and life are improved compared to a case in which the third emission portion EA1c of FIG. 6 is not present.

A display device including an organic light-emitting diode as a display element is described in more detail above for convenience. However, the present invention is not limited thereto, and the one or more embodiments described above may be applied to display devices of various suitable types, such as liquid crystal display devices, electrophoretic display devices, and inorganic electroluminescent (EL) display devices.

A display device according to the one or more embodiments described above may be implemented as an electronic device, such as smartphones, mobile phones, smart watches, navigation devices, game consoles, televisions (TVs), vehicle head units, laptop computers, tablet computers, personal media players (PMPs), and personal digital assistants (PDAs). In addition, the electronic device may be a flexible device.

According to the one or more embodiments of the present invention, a display device having improved display quality by dividing, into two areas, a pixel electrode of a display element having the largest area in a unit pixel area and an emission area corresponding thereto may be provided. In addition, in one or more embodiments of the present invention, because the emission area is divided in a direction in which area loss of the emission area is minimized or reduced, a display device having increased product life and improved display quality may be provided. However, the aspects and features of the present invention are not limited to those described above.

The foregoing is illustrative of some embodiments of the present invention, and is not to be construed as limiting thereof. Although some embodiments have been described, those skilled in the art will readily appreciate that various modifications are possible in the embodiments. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims.

## Claims

1. A display panel (10) comprising unit pixel areas (PXA) defined in a first direction (DR1) and a second direction (DR2) crossing the first direction (DR1), each of the unit pixel areas (PXA) comprising:
a first display element configured to emit light of a first color;
a second display element configured to emit light of a second color; and
a third display element configured to emit light of a third color,
wherein the first display element, the second display element, and the third display element are located along an oblique direction in each corresponding unit pixel area (PXA),
wherein a first emission area (EA1) corresponding to the first display element is greater than each of a second emission area (EA2) corresponding to the second display element and a third emission area (EA3) corresponding to the third display element,
wherein the first emission area (EA1) comprises a first emission portion (EA1a) and a second emission portion (EA1b) on a single first pixel electrode (121a), and spaced from each other with respect to a virtual center line (VCL1, VCL2, VCL3, VCL4) extending in a third direction (DR3), and
wherein a width (W1, W3, W5, W7) of the first emission area (EA1) in the third direction (DR3) is less than a width (W2, W4, W6, W8) of the first emission area (EA1) in a fourth direction (DR4) obliquely crossing the third direction (DR3).

2. The display panel (10) of claim 1, wherein a distance (d1) between the first emission portion (EA1a) and the second emission portion (EA1b) of the first emission area (EA1) is less than a distance (d2) between the second emission area (EA2) and the third emission area (EA3).

3. The display panel (10) of claim 1 or 2, wherein the first emission area (EA1) further comprises a third emission portion (EA1c) connecting between the first emission portion (EA1a) and the second emission portion (EA1b).

4. The display panel (10) of at least one of claims 1 to 3, wherein the unit pixel areas (PXA) comprise a first unit pixel area (PXA1) and a second unit pixel area (PXA2) alternately located with each other along the first direction (DR1),
wherein in the first unit pixel area (PXA1), the first emission portion (EA1a) and the second emission portion (EA1b) of the first emission area (EA1) are spaced from each other in a first oblique direction, and
wherein in the second unit pixel area (PXA2), the first emission portion (EA1a) and the second emission portion (EA1b) of the first emission area (EA1) are spaced from each other in a second oblique direction perpendicular to the first oblique direction.

5. The display panel (10) of at least one of claims 1 to 3, wherein the unit pixel areas (PXA) comprise a first unit pixel area (PXA1) and a second unit pixel area (PXA2) alternately located with each other along the first direction (DR1), and
wherein a direction in which the first emission portion (EA1a) and the second emission portion (EA1b) of the first emission area (EA1) located within the first unit pixel area (PXA1) are spaced from each other is the same as a direction in which the first emission portion (EA1a) and the second emission portion (EA1b) of the first emission area (EA1) located within the second unit pixel area (PXA2) are spaced from each other.

6. The display panel (10) of at least one of claims 1 to 5, wherein the third direction (DR3) is the oblique direction.

7. The display panel (10) of at least one of claims 1 to 5, wherein the third direction (DR3) is parallel to the first direction (DR1).

8. The display panel (10) of at least one of claims 1 to 7, wherein an angle between the third direction (DR3) and the fourth direction (DR4) is about 45°.

9. The display panel (10) of at least one of claims 1 to 8, wherein the unit pixel areas (PXA) comprise a first unit pixel area (PXA1) and a second unit pixel area (PXA2),
wherein in the first unit pixel area (PXA1), the second emission area (EA2) and the third emission area (EA3) face each other in a third oblique direction, and the first emission area (EA1) is adjacent to the second emission area (EA2) and the third emission area (EA3) in a fourth oblique direction, and
wherein in the second unit pixel area (PXA2), the third emission area (EA3), the second emission area (EA2), and the first emission area (EA1) are sequentially located to be adjacent to each other in the fourth oblique direction.

10. A display panel (10) comprising unit pixel areas (PXA) defined in a first direction (DR1) and a second direction (DR2) crossing the first direction (DR1), each of the unit pixel areas (PXA) comprising:
a first display element configured to emit light of a first color, and having at least one surface along an oblique direction;
a second display element configured to emit light of a second color; and
a third display element configured to emit light of a third color,
wherein the first display element is adjacent to the second display element and the third display element in the first direction (DR1), and the second display element and the third display element are adjacent to each other in the second direction (DR2),
wherein a first emission area (EA1) corresponding to the first display element comprises a first emission portion (EA1a) and a second emission portion (EA1b) on a single first pixel electrode (121a), and spaced from each other with respect to a virtual center line (VCL5) extending in a third direction (DR3), and
wherein a width (W9) of the first emission area (EA1) in the third direction (DR3) is less than a width (W10) of the first emission area (EA1) in a fourth direction (DR4) obliquely crossing the third direction (DR3).

11. The display panel (10) of claim 10, wherein each of a second emission area (EA2) corresponding to the second display element and a third emission area (EA3) corresponding to the third display element is less than the first emission area (EA1).

12. The display panel (10) of claim 10 or 11, wherein each of the second emission area (EA2) and the third emission area (EA3) has a triangular shape, a pentagonal shape, or a hexagonal shape.

13. The display panel (10) of at least one of claims 1 to 12, wherein the first pixel electrode (121a) comprises:
a first portion (121aa) and a second portion (121ab) spaced from each other with respect to the virtual center line (VCL1, VCL2,VCL3, VCL4, VCL5) extending in the third direction (DR3); and
a third portion (121ac) connecting between the first portion (121aa) and the second portion (121ab).

14. The display panel (10) of claim 13, wherein the first emission portion (EA1a) of the first emission area (EA1) is located on the first portion (121aa) of the first pixel electrode (121a), and the second emission portion (EA1b) of the first emission area (EA1) is located on the second portion (121ab) of the first pixel electrode (121a).

15. The display panel (10) of claim 14, wherein the first emission area (EA1) further comprises a third emission portion (EA1c) connecting between the first emission portion (EA1a) and the second emission portion (EA1b), and
wherein at least a portion of the third emission portion (EA1c) is located on the third portion (121ac) of the first pixel electrode (121a).

16. The display panel (10) of at least one of claims 13 to 15, wherein a pixel-defining layer (119) is located on at least a portion of the third portion (121ac) of the first pixel electrode (121a).

17. A display panel (10) comprising unit pixel areas (PXA) defined in a first direction (DR1) and a second direction (DR2) crossing the first direction (DR1), each of the unit pixel areas (PXA) comprising:
a first display element configured to emit light of a first color, and having at least one surface in an oblique direction;
a second display element configured to emit light of a second color; and
a third display element configured to emit light of a third color,
wherein a first emission area (EA1) corresponding to the first display element is greater than each of a second emission area (EA2) corresponding to the second display element and a third emission area (EA3) corresponding to the third display element,
wherein the first emission area (EA1) is on a single first pixel electrode (121a), and comprises a first emission portion (EA1a) and a second emission portion (EA1b) spaced from each other with respect to a virtual center line (VCL1, VCL2,VCL3, VCL4, VCL5) extending in a third direction (DR3), and
wherein a width (W1, W3, W5, W7, W9) of the first emission area (EA1) in the third direction (DR3) is less than a width (W2, W4, W6, W8, W10) of the first emission area (EA1) in a fourth direction (DR4) obliquely crossing the third direction (DR3).

18. The display panel (10) of at least one of claims 10 to 17, wherein at least one surface of each of the second emission area (EA2) and the third emission area (EA3) is located in an oblique direction.

19. The display panel (10) of claim 17 or 18, wherein the unit pixel areas (PXA) comprise a first unit pixel area (PXA1) and a second unit pixel area (PXA2) alternately located with each other in the first direction (DR1),
wherein in the first unit pixel area (PXA1), the second emission area (EA2) and the third emission area (EA3) face each other in a first oblique direction, and the first emission area (EA1) is adjacent to the second emission area (EA2) and the third emission area (EA3) in a second oblique direction, and
wherein in the second unit pixel area (PXA2), the third emission area (EA3), the second emission area (EA2), and the first emission area (EA1) are sequentially located to be adjacent to each other in the second oblique direction.

20. The display panel (10) of at least one of claims 17 to 19, wherein the unit pixel areas (PXA) comprise a first unit pixel area (PXA1) and a second unit pixel area (PXA2) alternately located with each other in the first direction (DR1),
wherein the first emission area (EA1) is adjacent to the second emission area (EA2) and the third emission area (EA3) in the first direction (DR1), and
wherein the second emission area (EA2) and the third emission area (EA3) are adjacent to each other in the second direction (DR2).
